# EUROPÄISCHE PATENTANMELDUNG

(11) **EP 4 219 391 A1**
(43) Veröffentlichungstag der Anmeldung: **02.08.2023**
(21) Anmeldenummer: 22153842.4
(22) Anmeldetag: 28.01.2022
(51) Int. Cl.: B81C 1/00

(54) **DURCHKONTAKTIERUNG ZUM BETREIBEN EINES MEMS-BAUTEILES IN EINER HERMETISCHEN KAVITÄT**

(71) Anmelder: Hahn-Schickard-Gesellschaft für angewandte Forschung e.V., 78052 Villingen-Schwenningen (DE)
(72) Erfinder: Spies, Irina, 78052 Villingen-Schwenningen Pfaffenweiler (DE); Auber, Johannes, 78052 Villingen-Schwenningen (DE); Nommensen, Peter, 78054 Villingen-Schwenningen (DE); Dehé, Alfons, 72770 Reutlingen (DE)
(74) Vertreter: Hertin und Partner Rechts- und Patentanwälte PartG mbB

(57) **Zusammenfassung**

Die Erfindung betrifft ein Verfahren zur Herstellung eines Halbleiterbauteils umfassend ein MEMS-Bauteil in einer hermetischen Kavität innerhalb eines von mindestens zwei Wafern gebildeten Waferstacks. Hierzu werden zunächst ein Active-Wafer und ein Cover-Wafer bereitgestellt. Durch ein Unterätzen mittels eines dampfförmigen Reaktanten werden MEMS-Strukturen für das MEMS-Bauteil freigestellt, indem eine mittlere Isolationsschicht des Active-Wafers in den entsprechenden Bereichen geätzt wird. Insbesondere wird an einem der Wafer ein Durchkontaktierungsbereich durch ein Bilden von vertikalen Gräben erstellt, wobei der Durchkontaktierungsbereich eine vertikale elektrische Verbindung bildet. Der Durchkontaktierungsbereich weist vorzugsweise zwei Anschlussbereiche auf, einen internen und externen. Der interne Anschlussbereich des Durchkontaktierungsbereiches wird durch eine Anschlussöffnung oder durch ein Anschlusskontaktbereich kontaktiert, wobei sich bei beiden Optionen die Kontaktierungen zum internen Bereich innerhalb der Device-Schicht des Active-Wafers befinden. Der externe Anschluss des Durchkontaktierungsbereiches wird mit einem Anschlusspad kontaktiert. Das erfindungsgemäße Verfahren zeichnet sich insbesondere durch die Möglichkeit der Bereitstellung diverser MEMS-Bauteile, insbesondere Gyroskope, auf robuste Weise und mit kosteneffizienten Mitteln aus.

In einem weiteren Aspekt betrifft die Erfindung ein Halbleiterbauteil, welches gemäß dem erfindungsgemäßen Verfahren hergestellt wurde.

## Beschreibung

Die Erfindung betrifft ein Verfahren zur Herstellung eines Halbleiterbauteils umfassend ein MEMS-Bauteil in einer hermetischen Kavität innerhalb eines von mindestens zwei Wafern gebildeten Waferstacks. Hierzu werden zunächst ein Active-Wafer und ein Cover-Wafer bereitgestellt. Durch ein Unterätzen mittels eines dampfförmigen Reaktanten werden MEMS-Strukturen für das MEMS-Bauteil freigestellt, indem eine mittlere Isolationsschicht des Active-Wafers in den entsprechenden Bereichen geätzt wird. Insbesondere wird an einem der Wafer ein Durchkontaktierungsbereich durch ein Bilden von vertikalen Gräben erstellt, wobei der Durchkontaktierungsbereich eine vertikale elektrische Verbindung bildet. Der Durchkontaktierungsbereich weist vorzugsweise zwei Anschlussbereiche auf, einen internen und externen. Der interne Anschlussbereich des Durchkontaktierungsbereiches wird durch eine Anschlussöffnung oder durch ein Anschlusskontaktbereich kontaktiert, wobei sich bei beiden Optionen die Kontaktierungen zum internen Bereich innerhalb der Device-Schicht des Active-Wafers befinden. Der externe Anschluss des Durchkontaktierungsbereiches wird mit einem Anschlusspad kontaktiert. Das erfindungsgemäße Verfahren zeichnet sich insbesondere durch die Möglichkeit der Bereitstellung diverser MEMS-Bauteile, insbesondere Gyroskope, auf robuste Weise und mit kosteneffizienten Mitteln aus.

In einem weiteren Aspekt betrifft die Erfindung ein Halbleiterbauteil, welches gemäß dem erfindungsgemäßen Verfahren hergestellt wurde.

### Hintergrund und Stand der Technik

Im Allgemeinen können verschiedene Bauteile mit Methoden der Halbleitertechnologe aufgebaut werden. Solche Bauteile bezeichnet man auch als Halbleiterbauteile. Halbleiterbauteile können insbesondere Strukturen aufweisen, welche Größen und Ausmaße im Mikrometerbereich haben. Wird eine mechanische Mikrostruktur mit einer elektrischen Schaltung kombiniert, spricht man auch von einem sogenannten MEMS (engl. *microelectromechanical* system).

MEMS-Bauteile können hierbei Logikelemente und mikromechanische Strukturen auf einem Chip vereinen. Aufgrund ihrer Fähigkeit mechanische und elektrische Signal zu verarbeiten und/oder zu erzeugen, zeichnen sie sich für eine Vielzahl von Anwendungen wie z.B. Sensoren, Aktoren, Filter und Oszillatoren aus.

In der heutigen Zeit bilden MEMS-Bauteile eine wichtige technische Grundlage für Lösungsansätze in der Mikroelektronik. Gegenüber konventionellen Makrosystemen bieten sie vor allem Vorteile in der Kostenersparnis durch einen geringen Verbrauch an Werkstoffen und/oder einer möglichen Parallelfertigung sowie in der Effizienz, welche durch einen geringeren Energie- und Leistungsbedarf ermöglicht wird.

Für einige Anwendungen ist es erforderlich, dass MEMS-Bauteile hermetisch abgeschlossen werden, um einen ausreichenden Schutz und somit zuverlässigen Betrieb sicherzustellen.

Gleichzeitig ist für die MEMS-Bauteile eine zuverlässige, schnelle sowie störungsfreie elektrische Ansteuerung erforderlich, um die Funktionalität zu sichern.

Aus dem Stand der Technik sind verschiedene MEMS-Bauteile und Herstellungsverfahren zur Bereitstellung der MEMS-Bauteile bekannt.

In DE 102005015584 B4 wird ein Verfahren zur Herstellung eines MEMS-Bauteils offenbart, bei dem sich bewegliche MEMS-Strukturen innerhalb eines Waferstacks befinden. Hierbei wird zunächst ein Substrat bereitgestellt und mit Kavitäten versehen. Anschließend wird eine Strukturschicht aufgetragen, wobei die Kavität des Substrates ungefüllt bleiben. Daraufhin wird die Strukturschicht strukturiert, sodass eine aktive Struktur gebildet wird. Zum Strukturieren werden Ätzverfahren eingesetzt. Für den Betrieb wird die aktive Struktur lateral elektrisch kontaktiert. Zur Abkapselung der MEMS-Strukturwird ein weiteres Substrat aufgetragen, wobei das erste Substrat derart strukturiert wird, dass Kontaktflächen von außen durch Bonddrähte an die Strukturschicht zur elektrischen Kontaktierung gebildet werden.

DE 60315749 offenbart ein Verfahren zur Herstellung eines MEMS-Bauteils, welcher durch eine Schutzkappe hermetisch versiegelt wird. Hierbei wird ein sogenanntes HF-Ätzen (HF steht für Hydrogenfluorid) eingesetzt, wodurch in einem Verfahrensschritt eine Opferschicht entfernt wird, um die MEMS-Strukturen beweglich zugestalten. Zunächst wird eine Kapselungsstruktur auf die Opferschicht beschichtet und anschließend geätzt. Durch die geätzten Bereiche gelangt der dampfförmige Hydrogenfluorid in das Innere des Bauteils, sodass eine Ätzung der Opferschicht ermöglicht wird.

EP 2377154 B1 offenbart eine Vorrichtung, bei der eine Durchkontaktierung zum Betreiben eines MEMS-Bauteils innerhalb einer Kavität eines gebondeten Waferstacks ausgebildet ist. Vorzugsweise werden hier zwei SOI-Wafer eingesetzt, wobei auch die Kombination eines gewöhnlichen Wafers mit einem SOI-Wafer möglich ist. Die Durchkontaktierung wird bevorzugt durch einen Durchkontaktierungsbereich aus einem dotierten Siliziumwafer gebildet, welcher von isolierenden Gräben eingeschlossen wird. Die Kontaktierung zum MEMS-Bauteil erfolgt mit einem elektrisch leitfähigen Stecker (*conductive plug*)*,* welcher durch eine mit Polysilizium gefüllte Öffnung gebildet wird. Der elektrisch leitfähige Stecker kann innerhalb des Waferstacks durch Isoliergräben eingeschlossen werden. Diese Isoliergräben können partiell oder vollständig mit einem Oxid als Isoliermaterial gefüllt werden, wobei sie auch lediglich mit Luft befüllt sein können. Die Durchkontaktierung erfolgt für den Betrieb einer MEMS-Vorrichtung mit auslenkbaren Elementen. Insbesondere können diese auslenkbaren Elemente für Mikrospiegel, Mikroschalter, optische Verstärker und Lautsprechermembranen vorgesehen sein.

In Bezug auf die Effizienz, Präzision und Wirtschaftlichkeit der im Stand der Technik bekannten Verfahren zur Herstellung von Halbleiterbauteilen mit einem MEMS-Bauteil in einer hermetischen Kavität innerhalb eines von mindestens zwei Wafern gebildeten Waferstacks besteht ein Bedarf an Verbesserung. Oftmals werden viele und aufwendige Verfahrensschritte benötigt, um beispielsweise bewegliche MEMS-Strukturen für einen MEMS-Bauteil bereitzustellen bzw. deren hermetischen Einschluss bei gleichzeitiger externer elektrischer Ansteuerung zu sichern.

Mit dem derzeitigen Stand der Technik ist es nicht möglich, effizient, zuverlässig, robust und wirtschaftlich Halbleiterbauteile herzustellen.

### Aufgabe der Erfindung

Aufgabe der Erfindung ist es, ein Verfahren zur Herstellung von Halbleiterbauteilen und damit auch ein Halbleiterbauteil bereitzustellen, welches die Nachteile des Standes der Technik beseitigt. Insbesondere ist es eine Aufgabe der Erfindung, Halbleiterbauteile umfassend MEMS-Bauteile auf eine besonders effiziente, zuverlässige, robuste und wirtschaftliche Weise herzustellen. Insbesondere war es hierbei eine Aufgabe der Erfindung die MEMS-Bauteile besonders gut hermetisch in einem Waferstack einzuschließen, während eine zuverlässige und störungsfreie elektrische Kontaktierung zum Betrieb des MEMS-Bauteils gewährleistet wird.

### Zusammenfassung der Erfindung

Die Aufgabe wird durch die Merkmale der unabhängigen Ansprüche gelöst. Bevorzugte Ausführungsformen der Erfindung sind in den abhängigen Ansprüchen beschrieben.

In einem ersten Aspekt betrifft die Erfindung ein Verfahren zur Herstellung eines Halbleiterbauteils, umfassend ein MEMS-Bauteil in einer hermetischen Kavität innerhalb eines von mindestens zwei Wafern gebildeten Waferstacks, umfassend die Schritte:
a) Bereitstellen eines Active-Wafers und eines Cover-Wafers, wobei der Active-Wafer eine Trägerschicht, eine mittlere Isolationsschicht und eine Device-Schicht aufweist,
b) Bilden von MEMS-Strukturen für das MEMS-Bauteil in der Device-Schicht des Active-Wafers und ein Freistellen der MEMS-Strukturen mithilfe eines Unterätzens
c) Bilden eines Anschlusskontaktbereiches in der Device-Schicht des Active-Wafers durch Bilden von Trenngräben, welche einen leitfähigen Bereich umschließen, oder durch Bilden einer Anschlussöffnung, welche mit einem Leitermaterial vollständig oder teilweise befüllt wird,
d) Bilden eines Durchkontaktierungsbereiches durch Bilden von vertikalen Gräben in der Trägerschicht des Active-Wafers oder in dem Cover-Wafer, welche den Durchkontaktierungsbereich umschließen,
e) Bonden des Active-Wafers mit dem Cover-Wafer zum hermetischen Einschluss des MEMS-Bauteils in einer Kavität des gebildeten Waferstacks und Anschluss des Durchkontaktierungsbereiches mit einer elektrischen Verbindung zum Betrieb des MEMS-Bauteils.

Das Halbleiterbauteil, das mittels des erfindungsgemäßen Verfahrens hergestellt werden konnte, hat sich in vielerlei Aspekten als sehr vorteilhaft erwiesen, die im Folgenden näher ausgeführt werden.

Vorteilhafterweise weisen die einzelnen Verfahrensschritte und damit das mittels des erfindungsgemäßen Herstellungsverfahrens hergestellte Halbleiterbauteil eine sehr geringe Fehleranfälligkeit auf. Dies lässt sich beispielsweise dadurch begründen, dass die MEMS-Strukturen vorzugsweise in der Device-Schicht eines Active-Wafers angebracht werden. Daher ist es nicht erforderlich, weitere Komponenten anzubringen, um die MEMS-Strukturen und damit das MEMS-Bauteil bereitzustellen. Aufwendige Prozessschritte werden vorteilhaft umgangen, um das MEMS-Bauteil innerhalb eines Waferstacks zu erstellen.

Weiterhin kann mittels des Verfahrens auf einfache Weise ein hermetischer Einschluss des MEMS-Bauteils innerhalb einer Kavität gewährleistet werden. Dadurch ergibt sich ein besonders guter Schutz des MEMS-Bauteils und damit auch eine Gewährleistung ausgezeichneter Funktionalität bei gleichzeitig langer Lebensdauer. Das MEMS-Bauteil ist damit besonders gut geschützt vor einem Stoffaustausch mit der Umgebung des MEMS-Bauteils oder des Halbleiterbauteils, so dass dessen Robustheit erhöht wird.

Durch den Umstand, dass das MEMS-Bauteil, wie beansprucht, unmittelbar innerhalb einer Kavität des Waferstacks eingebracht und über eine Durchkontaktierung angesteuert wird, kann weiterhin ein kompaktes Halbleiterbauteil bereitgestellt werden. Dadurch kann das Halbleiterbauteil auch in sehr beengten Raumbereichen eingebracht werden, bei gleichzeitig guter und zuverlässiger Funktionalität. Daher ist das Halbleiterbauteil auch flexibel in ihrem Einbau-, aber auch in ihrem Einsatzbereich. Die Verfahrensschritte zur Herstellung und Freistellung der MEMS-Strukturen für das Halbleiterbauteil sind zudem vorteilhaft geeignet, eine Vielzahl von Strukturen und somit Sensoren bereitzustellen.

Ein weiterer Vorteil ist es, dass durch die Ausgestaltung sowie Anordnung des Durchkontaktierungsbereiches die elektrische Kontaktierung bzw. der Stromfluss besonders verlustfrei bereitgestellt werden kann. Der Durchkontaktierungsbereich weist zwei Anschlussbereiche für die elektrische Kontaktierung auf, einen inneren und einen äußeren Anschlusskontaktbereich. Durch die Kontaktierung des inneren Anschlussbereiches mit der Anschlussöffnung oder dem Anschlusskontaktbereich vorzugsweise in der Device-Schicht des Active-Wafers liegt eine auf einfache Weise bereitgestellte und sichere elektrische Kontaktierung vor. Weiterhin kann der Durchkontaktierungsbereich vorteilhafterweise derart ausgestaltet werden, dass der Innenwiderstand verringert wird, beispielsweise durch ein geeignetes Aspektverhältnis des Durchkontaktierungsbereiches über die Ausbildung der vertikalen Gräben.

Es ist auch vorteilhaft, dass mögliche auftretende parasitäre Kapazitäten durch die Ausgestaltung der vertikalen Gräben und/oder der Trenngräben verringert werden können, wobei vorzugsweise die vertikalen Gräben den Durchkontaktierungsbereich und die Trenngräben den Anschlusskontaktbereich oder die Anschlussöffnung voneinander isolieren.

Des Weiteren ist das erfindungsgemäße Verfahren vorteilhafterweise besonders effizient in Hinblick auf die Wirtschaftlichkeit, da es beispielsweise möglich ist, falls als Active-Wafer bevorzugt ein SOI-Wafer eingesetzt wird, lediglich einen SOI-Wafer einzusetzen, anstelle von zwei oder mehr SOI-Wafer. Üblicherweise sind die Produktion und der Kauf von einem SOI-Wafer mit höheren Kosten verbunden als bei einem gewöhnlichen Wafer. Durch die Kombination eines SOI-Wafers als Active-Wafer und eines gewöhnlichen Wafers als Cover-Wafer, zur Fertigung eines Halbleiterbauteils können damit Kosten gespart werden. Damit eignet sich das erfindungsgemäße Verfahren vorteilhafterweise auch besonders gut für eine Massenproduktion.

Vorzugsweise dient das erfindungsgemäße Verfahren der Herstellung eines Halbleiterbauteils. Im Sinne der Erfindung bezeichnet ein Halbleiterbauteil bevorzugt ein Bauelement, welches man für Schaltungen in der Elektrotechnik oder der Elektronik insbesondere im Zusammenhang mit Halbleitermaterialien verwendet. Der durchschnittliche Fachmann weiß, dass der Begriff des Halbleiterbauteils weit ausgelegt werden kann. Beispielsweise kann ein Halbleiterbauteil einen integrierten Schaltkreis umfassen, der Transistoren und/oder Dioden aufweist oder selbst ein solches Bauteil sein. Vorzugsweise erfolgt die Fertigung der integrierten Schaltkreise auf Wafern, die insbesondere ein Halbleitermaterial umfassen können, jedoch nicht darauf beschränkt sind. Zudem können durch Bearbeitung des Wafermaterials Bauelemente wie Transistoren, Dioden und/oder Kondensatoren hergestellt werden. Es können auch mehrere Wafer eingesetzt werden, die dann zerteilt werden und mehrere Chips bilden können. Ein Halbleiterbauteil kann auch beispielsweise eine Leiterplatte, mehrere Prozessoren, Halbleiterspeicher, Mikrocontroller, Wandler, Mikrochips etc. umfassen oder selbst sein.

Insbesondere umfasst ein Halbleiterbauteil auch Bauteile, die im Zusammenhang mit der 3D-Integration auftreten. Die 3D-Integration bezeichnet bevorzugt eine integrierte Schaltung, bei der die aktiven elektronischen Komponenten sowohl horizontal als auch vertikal in zwei oder mehr Schichten integriert sind, d. h., zu einem einzigen Schaltkreis verbunden sind, einem sogenannten dreidimensional-integrierten Schaltkreis (3D-IC).

Vorzugsweise befindet sich ein MEMS-Bauteil und/oder eine elektronische Schaltung innerhalb einer Kavität eines Wafers oder eines Waferstacks des Halbleiterbauteils. Ein MEMS-Bauteil bezeichnet bevorzugt ein Bauteil oder eine Komponente, welches auf MEMS-Technologie beruht. Die MEMS-Technologie umfasst Techniken, Materialien und Verfahren der Halbleiter- und der Mikrosystemtechnik, um MEMS-Bauteile herzustellen. Durch ein MEMS-Bauteil wird eine kompakte Bauweise (im Mikrometerbereich) bei gleichzeitig hervorragender Funktionalität mit immer geringeren Herstellungskosten erreicht. Ein MEMS-Bauteil kann beispielsweise ein MEMS-Sensor oder auch ein MEMS-Aktuator sein. Im Stand der Technik sind viele MEMS-Bauteile bekannt. Vorteilhafterweise können durch das erfindungsgemäße Verfahren verschiedenste MEMS-Bauteile durch eine Verbindung mit dem Durchkontaktierungsbereich betrieben werden. Insbesondere umfasst das MEMS-Bauteil MEMS-Strukturen. Dies kann beispielsweise eine Anordnung von Waferabschnitten sein, die einen Abstand im Mikrometerbereich voneinander haben. Insbesondere können sich die MEMS-Strukturen bewegen und/oder schwingen, wodurch eine Vielzahl von möglichen MEMS-Bauteilen bereitgestellt werden können, wie beispielsweise Beschleunigungssensoren und/oder Gyroskope.

Das MEMS-Bauteil kann vorzugsweise in Kombination mit einer elektronischen Schaltung vorliegen. Bevorzugte elektronische Schaltungen umfassen ohne Beschränkung eine integrierte Schaltung (IC), eine anwendungsspezifische integrierte Schaltung (ASIC), eine programmierbare logische Schaltung (PLC), ein Field Programmable Gate Array (FPGA), einen Mikroprozessor, einen Mikrocomputer, eine speicherprogrammierbare Steuerung und/oder eine sonstige elektronische Schaltung, die bevorzugt programmierbar ist.

Es kann auch bevorzugt sein, dass beispielsweise zwei oder mehr Wafer zu einem Waferstack gebildet werden, die eine Kavität umfassen, worin sich das MEMS-Bauteil und/oder die elektronische Schaltung befinden.

Im Sinne der Erfindung bezeichnet eine Kavität vorzugsweise eine Vertiefung in einen Wafer. Vorteilhafterweise kann durch das Vorhandensein einer oder mehrerer Kavitäten ein geeigneter Hohlraum für das MEMS-Bauteil und/oder die elektronische Schaltung bereitgestellt werden. Hierdurch kann das MEMS-Bauteil innerhalb des Halbleiterbauteils robust und stabil platziert sein. Bevorzugt ist die Kavität für die Platzierung des MEMS-Bauteils vakuumdicht.

Der Ausdruck "hermetische Kavität" meint im erfindungsgemäßen Kontext vorzugsweise, dass das MEMS-Bauteil innerhalb der Kavität des Waferstacks hermetisch abgeschlossen wird, wobei ein hermetischer Verschluss bevorzugt einen dichten Verschluss meint, welcher einen Stoffaustausch mit der Umgebung verhindert. Vorteilhaft wird durch eine hermetische Kavität eine besonders robuster Schutz für das MEMS-Bauteil und/oder der Kavität als solche ermöglicht, wodurch sich ein gewünschter Gasdruck einstellen und/oder Kontamination verhindert wird.

In bevorzugten Ausführungsformen kann die Kavität vakuumdicht sein. Der Ausdruck "vakuumdicht" bezeichnet hierbei vorzugsweise einen dichten Verschluss der Kavität, welcher einen langanhaltenden, d. h. dauerhaften, Zustand des Vakuums innerhalb der Kavität. Das Vakuum innerhalb der Kavität wird durch einen Druck innerhalb der Kavität oder durch einen Druckunterschied zu einem Druck, der außerhalb der Kavität oder des Halbleiterbauteils vorliegt, beschrieben. Das Vakuum in der Kavität kann insbesondere durch einen Unterdruck beschrieben werden. Beispielsweise kann innerhalb der Kavität ein Druck von bis zu 100 000 Pa (Pascal), bevorzugt bis zu 100 Pa, besonders bevorzugt bis zu 10 Pa, ganz besonders bevorzugt bis zu 1 Pa, stark bevorzugt bis zu 10⁻⁵ Pa, ganz stark bevorzugt bis zu 10⁻¹⁰ Pa, stärker bevorzugt bis zu 10⁻¹⁵ Pa vorliegen, am stärksten bevorzugt bei ca. 0 Pa. Der durchschnittliche Fachmann weiß, dass in der Realität ein Vakuum niemals absolut ist, sondern sich durch einen erheblich geringeren Druck gegenüber dem Atmosphärendruck bei Normalbedingungen auszeichnet. Ein Unterdruck bezeichnet bevorzugt einen relativen Druck, der unter dem Umgebungsdruck liegt. Eine vakuumdichte Kavität ist besonders vorteilhaft für einen Schutz des MEMS-Bauteils oder der MEMS-Strukturen, um Kontaminationen mit fremden Substanzen zu verhindern. Insbesondere erlaubt ein vakuumdichter Verschluss eine bessere Beweglichkeit der MEMS-Strukturen, wodurch sich eine höhere Sensitivität und Güte (Q-Faktor) ergibt. Damit ergibt sich ein kombinatorischer technischer Effekt durch die vakuumdichte Kavität, nämlich ein besonders guter Schutz und eine bessere Beweglichkeit der MEMS-Strukturen.

Begriffe wie im Wesentlichen, ca. etc. beschreiben bevorzugt einen Toleranzbereich von weniger als ± 40 %, bevorzugt weniger als ± 20 %, besonders bevorzugt weniger als ± 10 %, noch stärker bevorzugt weniger als ± 5 % und insbesondere weniger als ± 1 % und umfassen insbesondere den exakten Wert. Ähnlich beschreibt bevorzugt Größen, die ungefähr gleich sind. Teilweise beschreibt bevorzugt zu mindestens 5 %, besonders bevorzugt zu mindestens 10 %, und insbesondere zu mindestens 20 %, in einigen Fällen zu mindestens 40 %.

Ein Wafer kann beispielsweise eine kreisrunde oder quadratische Scheibe bezeichnen, die eine Dicke im Millimeter oder Submillimeter-Bereich aufweist. Wafer werden typischerweise aus ein- oder polykristallinen (Halbleiter-)Rohlingen, sogenannten Ingots, hergestellt und dienen in der Regel als Substrat für z. B. Beschichtungen oder Bauteile, insbesondere MEMS-Bauteile und/oder elektronische Schaltungen. Die Verwendung des Begriffs Substrat für den Wafer ist im Stand der Technik auch bekannt, wobei das Substrat vorzugsweise das zu behandelnde Material und/oder das zu beschichtende Material bezeichnet. Im Sinne der Erfindung können die Begriffe Wafer und Substrat synonym verwendet werden. Wenn der Begriff "Wafer" verwendet wird, können die Ausführungen sowohl den Cover-Wafer als auch den Active-Wafer betreffen.

Der Wafer kann Materialien ausgewählt aus der Gruppe umfassend monokristallines Silizium, Polysilizium, Siliziumdioxid, Siliziumcarbid, Siliziumgermanium, Siliziumnitrid und andere Halbleiter-Nitridverbindungen, Germanium, Kohlenstoff, Galliumarsenid, Indiumphosphid und/oder Glas umfassen.

Diese Materialien sind in der Halbleiter- und/oder Mikrosystemtechnik besonders einfach und kostengünstig zu bearbeiten und eignen sich ebenfalls gut für eine Massenherstellung. Ebenso sind diese Materialien für ein Dotieren und/oder ein Beschichten besonders gut geeignet, um in bestimmten Bereichen die gewünschten elektrischen, thermischen und/oder optischen Eigenschaften zu erzielen. Die vorgenannten Materialien bieten vielfältige Vorteile aufgrund der Verwendbarkeit standardisierter Herstellungstechniken, welche für die Integration von weiteren Komponenten, wie z. B. elektronischen Schaltungen, ebenfalls besonders geeignet sind.

Ein Waferstack wird vorzugsweise aus mindestens zwei Wafern gebildet, kann aber auch 3, 4, 5, 6, 7, 8, 9, 10, 15, 20, 50 oder mehr Wafer umfassen. Die Wafer können dabei sowohl horizontal als auch vertikal in zwei oder mehr Schichten miteinander verbunden werden, sodass sich eine dreidimensionale Ausgestaltung bildet. Vertikale elektrische Verbindungen zwischen verschiedenen Wafern werden dabei durch Durchkontaktierungsbereiche ermöglicht. Auch ist es bevorzugt, dass sich zwischen den Wafern eines Waferstacks weitere Schichten, wie beispielsweise eine oder mehrere Oxidschichten, befinden. Auch der Einsatz eines oder mehrerer Active-Wafer kann bevorzugt sein.

In bevorzugten Ausführungsformen kann der Waferstack durch ein EPyC-Prozess (engl. Epitaxial Polysilicon Cycle) bereitgestellt werden. Vorzugsweise wird hierbei epitaktisches Polysilizium als Funktions- und Opfermaterial eingesetzt. Das Funktionsmaterial bezeichnet bevorzugt ein Material, das für die Bereitstellung des Halbleiterbauteils und/oder des MEMS-Bauteil relevant ist und bevorzugt ein Teil davon bildet und/oder eine Funktion für das Halbleiterbauteil und/oder das MEMS-Bauteil erfüllt. Opfermaterial bezeichnet bevorzugt ein Material, das im Laufe des bevorzugten Herstellungsverfahrens entfernt werden kann, beispielsweise durch Ätzung. Bevorzugt basiert der zugrunde liegende EPyC-Prozess auf abwechselndem Abscheiden von epitaktischem Polysilizium und einem Oxid (siehe auch DE 102015206 96 A1). Epitaktisches Polysilizium bezeichnet bevorzugt Polysilizium, das epitaxial (d. h. durch Epitaxie) aufgetragen wird.

Der Active-Wafer bezeichnet bevorzugt einen Wafer, in dem die MEMS-Strukturen gebildet werden. Die Device-Schicht bezeichnet bevorzugt eine Schicht, in dem das MEMS-Bauteil bereitgestellt werden kann und wird mittels der Isolationsschicht von der Trägerschicht getrennt.

Für den Ausdruck des "Active-Wafer" kann es auch bevorzugt sein den Begriff des "Device-Wafers" zu verwenden.

Bei dem Active-Wafer handelt es bevorzugt sich um einen SOI-Wafer Ein SOI-Wafer (engl. *silicon on insulator,* d. h. Silizium auf einem Isolator) ist ein Waferstack, der zwei Wafer aus Silizium umfasst, wobei sich zwischen den beiden Wafern eine Isolationsschicht befindet. Daher ist es auch üblich, die Schichten des SOI-Wafers mit folgenden drei Bezeichnungen zu versehen: Eine Device-Schicht, die auch als Active-Schicht bezeichnet wird, die mittlere Isolationsschicht (engl. *buried oxide layer,* BOX, auch Oxidschicht, Isolierschicht oder auch Isolatorschicht genannt) und eine Trägerschicht (engl. *handle layer* oder *base layer*)*.* Vorzugsweise befindet sich in der Device-Schicht das MEMS-Bauteil. Die Isolationsschicht trennt die Device-Schicht von der Trägerschicht. Die Isolationsschicht eignet sich auch gut, um einen Stoppbereich bereitzustellen, falls ein Ätzen in den SOI-Wafer gewünscht ist, beispielsweise für die Bildung von MEMS-Strukturen. Die Trägerschicht, welche vorzugsweise dicker ist als die Device-Schicht, hat bevorzugt eine Stützfunktion. Mithilfe von SOI-Wafern werden vorteilhafterweise kürzere Schaltzeiten und geringere Leistungsaufnahmen, besonders bezüglich Leckströmen, ermöglicht. Der Einsatz eines einzelnen SOI-Wafers im erfindungsgemäßen Herstellungsverfahren in Kombination mit einem einfachen Wafer ist dahingehend vorteilhaft, dass die Produktion und/oder der Kauf von SOI-Wafern teurer ist, als für einfache Wafer. Durch den Aufbau eines SOI-Wafers als Active-Wafer in Kombination mit einem gewöhnlichen Wafer als Cover-Wafer können mithin Produktionskosten gespart werden. Wie weiter oben angedeutet, ist ein SOI-Wafer für die Bildung von MEMS-Strukturen oder das MEMS-Bauteil dahingehend vorteilhaft, dass die Isolationsschicht als Opferschicht, insbesondere als Stoppschicht, eingesetzt werden kann. Typischerweise werden in der Mikrosystemtechnik MEMS-Strukturen durch Ätzverfahren gebildet. Die Isolationsschicht schützt die Trägerschicht während der Herstellung der MEMS-Strukturen und bildet einen Endpunkt für die Bildung der MEMS-Strukturen. Darüber hinaus kann die Isolationsschicht in weiteren Verfahrensschritten - beispielsweise zur Freistellung beweglicher MEMS-Strukturen - prozessiert werden.

Der Cover-Wafer bezeichnet bevorzugt einen Wafer, mit dem das MEMS-Bauteil abgedeckt bzw. eingeschlossen werden kann. Der Cover-Wafer kann ein gewöhnlicher Wafer oder ein SOI-Wafer sein. Aus dem eben geschilderten Grund der Wirtschaftlichkeit ist der Einsatz eines gewöhnlichen Wafers als Cover-Wafer in Kombination mit einem SOI-Wafer bevorzugt. Daher wird vorzugsweise zu Beginn des erfindungsgemäßen Verfahrens ein SOI-Wafer als Active-Wafer und ein Cover-Wafer bereitgestellt.

Bevorzugt werden MEMS-Strukturen für das MEMS-Bauteil durch ein Ätzverfahren in die Device-Schicht des Active-Wafers angebracht. Weiterhin ist es bevorzugt, dass die MEMS-Strukturen durch ein Unterätzen, vorzugsweise mittels eines dampfförmigen Reaktanten, freigestellt werden. Vorteilhafterweise ist durch das Unterätzen, vorzugsweise mittels eines dampfförmigen Reaktanten, es möglich besonders filigrane MEMS-Strukturen für das MEMS-Bauteil innerhalb einer Kavität bereitzustellen. Dazu werden bevorzugt die MEMS-Strukturen in der Device-Schicht des Active-Wafers angebracht, wobei die Freistellung der MEMS-Strukturen bevorzugt durch das Unterätzen, vorzugsweise mittels eines dampfförmigen Reaktanten, erfolgt. Hierbei bezeichnet das Freistellen der MEMS-Strukturen vorzugsweise die Ermöglichung von beweglichen Freiheitsgraden in Bezug auf die gewünschte Funktionalität. Im erfindungsgemäßen Kontext wird das Unterätzen bevorzugt dazu eingesetzt, um die Isolationsschicht derart zu ätzen, sodass die MEMS-Strukturen freigestellt werden.

Im Sinne der Erfindung bezeichnet ein Unterätzen bevorzugt einen Ätzprozess, bei dem der Ätzangriff nicht nur senkrecht zur Waferoberfläche, sondern vorzugsweise auch parallel zur Waferoberfläche erfolgt. Hierdurch erfolgt eine Ätzung vorzugsweise unterhalb einer Ätzmaske oder in vergrabenen Schichten eines Wafers, beispielsweise einer Isolationsschicht, welche sich in Ätzrichtung hinter einer Trägerschicht befindet.

In bevorzugten Ausführungsformen erfolgt das Unterätzen mittels eines dampfförmigen Reaktanten. Ein dampfförmiger Reaktant für das Unterätzen hat sich dahingehend als vorteilhaft erwiesen, dass dieser sich besonders effizient in Gräben und/oder Kavitäten ausbreitet, um durch eine chemische Reaktion beispielsweise zur Ätzung der Isolationsschicht des Active-Wafers zu bewirken. Daher ist mithilfe eines dampfförmigen Reaktantens eine optimale Ätzung vorteilhaft durchführbar. Ein dampfförmiger Reaktant bezeichnet im Sinne der Erfindung vorzugsweise eine dampfförmige Substanz, die insbesondere für die Ätzung eingesetzt wird und sich vorzugsweise isotrop und somit auch im Wesentlichen parallel zur Waferoberfläche ausbreiten kann. Nicht beschränkende Beispiele für dampfförmige Reaktanten sind dampfförmige, wasserarme Halogenwasserstoffen, wie beispielsweise Hydrogenfluorid und/oder Edelgasverbindungen, wie beispielsweise Xenondifluorid. Das Unterätzen mittels eines dampfförmigen Reaktanten kann im erfindungsgemäßen Kontext auch als "Unterdampfätzen" bezeichnet werden. Insbesondere wird es vorteilhafterweise ermöglicht, durch das Unterätzen mithilfe eines dampfförmigen Reaktantens eine effiziente Beweglichkeit der MEMS-Strukturen zu ermöglichen.

Vorteilhafterweise kann durch eine Beweglichkeit von MEMS-Strukturen eine Reihe von möglichen MEMS-Bauteilen im Kontext des erfindungsgemäßen Verfahrens hergestellt werden. Die Isolationsschicht des Active-Wafers wird bevorzugt mit dampfförmigen, wasserarmen Halogenwasserstoffen wie beispielsweise Hydrogenfluorid und/oder Edelgasverbindungen wie beispielsweise Xenondifluorid isotrop geätzt, um die MEMS-Strukturen freizulegen bzw. freizustellen. Vorzugsweise eignen sich die genannten Substanzen als dampfförmige Reaktanten.

Im Stand der Technik ist es hingegen oft üblich, isotrope Nassätzverfahren einzusetzen. Allerdings können diese nachteilhaft sein, da hier das Phänomen der sogenannten Stiction (engl. Ausdruck für Haftreibung) auftritt. Unter diesem Phänomen ist bevorzugt das langanhaltende Anhaften der freistehenden Struktur am darunter liegenden Substrat aufgrund von Oberflächeneffekten gemeint, die während des Trocknens der Säure entstehen. Das Dampfätzen überwindet dies vorteilhafterweise, da keine Reaktanten im flüssigen Zustand während des Ätzprozesses verwendet werden. Üblicherweise werden Hydrogenfluorid und Xenondifluorid zum Ätzen von beispielsweise Siliziumdioxid und anderen Opferschichten eingesetzt.

Bevorzugt wird ein Anschlusskontaktbereich oder eine Anschlussöffnung in der Device-Schicht des Active-Wafers gebildet. Die Trenngräben dienen bevorzugt der Erstellung des Anschlusskontaktbereiches und der Isolierung des Anschlusskontaktbereiches. Das ist deshalb vorteilhaft, weil eine prozesseffiziente Kontaktierung mit dem internen Bereich des Durchkontaktierungsbereiches ausgeführt werden kann. Der Anschlusskontaktbereich umfasst einen leitfähigen Bereich und wird bevorzugt mit dem Durchkontaktierungsbereich elektrisch kontaktiert. Der vorzugsweise vertikale Stromfluss erfolgt über den Durchkontaktierungsbereich und dem Anschlusskontaktbereich.

Trenngräben stellen bevorzugt vertikale Vertiefungen im Wafer dar, die den Anschlusskontaktbereich oder die Anschlussöffnung umschließen und isolieren. Auch diese können mit einem Verfüllmaterial befüllt werden. Das Verfüllmaterial der Trenngräben kann im erfindungsgemäßen Kontext auch als zweites Verfüllmaterial bezeichnet werden. Ebenso ist es bevorzugt, dass die Trenngräben ungefüllt sind, wobei sich besonders bevorzugt darin ein Vakuum befindet.

Die Anschlussöffnung kann vollständig oder teilweise mit einem elektrisch leitfähigen Material befüllt werden und dient ebenso der Kontaktierung des internen Bereiches des Durchkontaktierungsbereiches. Auch die Anschlussöffnung wird bevorzugt innerhalb der Device-Schicht des Active-Wafers, bevorzugt des SOI-Wafers, gebildet, wodurch vorteilhaft eine besonders wirksame elektrische Kontaktierung erreicht wird.

Je nach Anwendung und gewünschter elektrischer Kontaktierung, insbesondere mit dem internen Bereich des Durchkontaktierungsbereiches, zeichnet sich das erfindungsgemäße Verfahren vorteilhafterweise durch eine erhöhte Flexibilität aus.

Vorzugsweise wird der Durchkontaktierungsbereich durch Bilden von vertikalen Gräben in der Trägerschicht des Active-Wafers gebildet. Alternativ kann der Durchkontaktierungsbereich durch das Erstellen von vertikalen Gräben in dem Cover-Wafer gebildet werden. Ein Durchkontaktierungsbereich bezeichnet im Sinne der Erfindung bevorzugt eine vertikale elektrische Verbindung, um Strom zwischen verschiedenen Leiterbahnebenen und/oder Leiterbahnabschnitten zu leiten. Der Durchkontaktierungsbereich wird bevorzugt durch die vertikalen Gräben gebildet, die einen elektrisch leitfähigen Bereich umschließen. Je nach Verwendungszweck und Anwendungsfall kann der Durchmesser und gegebenenfalls die Form des Durchkontaktierungsbereiches unterschiedlich ausgebildet werden. Vorteilhafterweise kann der Durchkontaktierungsbereich auch ausgebildet werden, um ein geeignetes Aspektverhältnis (Verhältnis aus Länge zu Querschnitt) aufzuweisen, um einen möglichst geringen Innerwiderstand zu besitzen. Mit Hilfe des Durchkontaktierungsbereiches ist es vorteilhafterweise möglich, die Leiterbahnebenen zwischen zwei- oder mehrlagigen Wafern zu wechseln. Synonym kann für den Begriff Durchkontaktierungsbereich auch der Begriff Durchkontaktierung verwendet werden.

Im Falle eines Silizium-Wafers ist es üblich, den Ausdruck Silizium-Durchkontaktierung (engl. *through silicon via,* TSV) zu verwenden. Diese wird in verschiedene Klassen eingeteilt. Via-first TSVs werden vor den aktiven Bauelementen (Transistoren usw., auch als Front-End of Line, FEOL, bezeichnet) prozessiert. Via-middle TSVs strukturiert man nach den aktiven Bauelementen, aber vor deren Verdrahtung (Metallisierung, auch als Back-End of Line, BEOL, bezeichnet). Via-last TSVs werden schließlich nach (oder während) des Aufbringens der Verdrahtungsmetallisierung, also dem BEOL, implementiert.

Vertikale Gräben sind vorzugsweise vertikale Vertiefungen im Wafer, die den Durchkontaktierungsbereich umschließen. Die vertikalen Gräben werden ausgehend von einer Oberflächenseite des Wafers gebildet. Nach ihrer Bildung werden sie bevorzugt mit einem Verfüllmaterial befüllt, welches vorzugsweise ein Dielektrikum ist. Das Verfüllmaterial der vertikalen Gräben kann im erfindungsgemäßen Kontext auch als erstes Verfüllmaterial bezeichnet werden.

Es kann auch bevorzugt sein, dass das Halbleiterbauteil mehrere Durchkontaktierungsbereiche umfasst, die entsprechend von mehreren vertikalen Gräben und/oder Trenngräben umschlossen werden. Mehrere Durchkontaktierungsbereiche und Anschlusskontaktbereiche können vorteilhafterweise in mehreren und unterschiedlichen Abschnitten des Halbleiterbauteils Strom transportieren. Durch die Mehrzahl der vertikalen Gräben und Trenngräben ergibt sich zudem vorteilhafterweise eine höhere Biegsamkeit des Halbleiterbauteils, sodass das Halbleiterbauteil nicht auf feste äußere Formen, beispielsweise beim Einbau in ein weiteres Gerät, räumlich eingeschränkt ist.

Vorzugsweise weist der Durchkontaktierungsbereich einen internen und einen externen Anschlussbereich auf. Diese beiden Anschlussbereiche müssen elektrisch kontaktiert werden, um einen geschlossenen Stromkreis zu bilden und damit den Betrieb des MEMS-Bauteils zu ermöglichen. Der interne Anschlussbereich bezeichnet einen Bereich, der bevorzugt innerhalb des Halbleiterbauteils elektrisch kontaktiert werden kann. Der externe Anschlussbereich bezeichnet bevorzugt einen Bereich, der von außen elektrisch kontaktierbar ist.

Für den Betrieb des MEMS-Bauteils wird der Durchkontaktierungsbereich bevorzugt mit einer elektrischen Verbindung angeschlossen. Hierdurch wird ein geschlossener Stromkreis zur Inbetriebnahme des MEMS-Bauteils ermöglicht.

Die elektrische Verbindung umfasst insbesondere eine Leiterbahn, die bevorzugt mit dem Durchkontaktierungsbereich derart kontaktiert wird, dass andere Bereiche des Halbleiterbauteils mit der Leiterbahn nicht kontaktiert werden oder sich berühren, außer dem Durchkontaktierungsbereich. Hierzu kann beispielsweise ein Anschlusspad, welches mit dem Durchkontaktierungsbereich kontaktiert wird, mit einer Leiterbahn kontaktiert werden, wobei zwischen dem umgebenden Bereich und der Leiterbahn ein isolierendes Material vorliegt, um beispielsweise Kurzschlüsse zu vermeiden.

Durch das Bonden des Active-Wafers mit dem Cover-Waferwird das MEMS-Bauteil hermetisch innerhalb einer Kavität eingeschlossen und ein Anschluss des Durchkontaktierungsbereiches mit einer elektrischen Verbindung ermöglicht.

Es ist besonders vorteilhaft, dass in dem erfindungsgemäßen Verfahren der Cover-Wafer keine aufwendige Strukturierung benötigt. Stattdessen kann der hermetische Einschluss der MEMS-Strukturen und damit des MEMS-Bauteils in einer Kavität mit einem im Wesentlichen unstrukturierten Cover-Wafer erfolgen. Dies ist insbesondere der Fall, sofern der Durchkontaktierungsbereich in der Trägerschicht des Active-Wafers selbst gebildet wird. Sofern der Durchkontaktierungsbereich in den Cover-Wafer eingebracht wird, ist im Wesentlichen lediglich die Ausbildung von vertikalen Gräben notwendig.

Der Anschluss des Durchkontaktierungsbereiches mit einer elektrischen Verbindung umfasst bevorzugt die Verbindung des Durchkontaktierungsbereiches mit einer Leiterbahn, um einen elektrischen Kontakt zum Durchkontaktierungsbereich herzustellen. Insbesondere wird dabei der externe Anschlussbereich des Durchkontaktierungsbereiches elektrisch kontaktiert.

Leiterbahnen (auch Leitbahn oder Leitungsbahn genannt) bezeichnen bevorzugt elektrisch leitende Verbindungen mit zweidimensionalem Verlauf, das heißt entlang einer Ebene, der sogenannten Leiterbahn- oder Metallisierungsebene. Sie werden bevorzugt zur Verbindung von elektronischen Bauelementen auf Leiterplatten und integrierten Schaltkreisen eingesetzt, das heißt, sie dienen zur Strom- bzw. Spannungsversorgung und/oder zur Signalübertragung. Die Verbindung zwischen einzelnen Leiterbahnebenen erfolgt vorzugsweise mithilfe des Durchkontaktierungsbereiches. Damit keine Kurzschlüsse oder hohen Verlustströme auftreten, müssen die Leiterbahnen elektrisch gut voneinander isoliert sein. Aufgrund des Schichtaufbaus einer Verdrahtung mit mehreren Ebenen können hierbei zusätzliche Dielektrika zum Einsatz kommen. Solche Dielektrika werden hinsichtlich ihrer Funktion in zwei Klassen aufgeteilt: ein Dielektrikum zwischen den Leiterbahnen in einer Ebene (inter-metal dielectric, IMD) und ein Dielektrikum zwischen zwei Leiterbahnebenen (inter-level dieletric, ILD). Vorteilhafterweise kann der externe Anschlussbereich des Durchkontaktierungsbereiches rückseitig elektrisch kontaktiert werden, was besonders einfach durchführbar ist und eine stabile elektrische Kontaktierung für einen dauerhaften Betrieb ermöglicht.

Durch die Verbindung zwischen Durchkontaktierungsbereich, MEMS-Bauteil, einer evtl. vorhandenen elektronischen Schaltung und einer Leiterbahnebene kann Strom zwischen einer Leiterbahnebene über den Durchkontaktierungsbereich zum MEMS-Bauteil für den Betrieb geleitet werden. Insbesondere kann dies erfolgen, wenn das MEMS-Bauteil in der Kavität verkapselt und besonders geschützt wird.

Das erfindungsgemäße Verfahren ist vorteilhafterweise schnell, einfach, zuverlässig und effizient durchführbar. Insbesondere ist das Verfahren kostengünstig und eignet sich besonders gut für eine Massenproduktion.

In einer weiteren bevorzugten Ausführungsform ist das Verfahren dadurch gekennzeichnet, dass der Anschlusskontaktbereich in der Device-Schicht des Active-Wafers und der Durchkontaktierungsbereich in dem Cover-Wafer gebildet wird, wobei das Bonden des Active-Wafers mit dem Cover-Wafer derart erfolgt, dass der Durchkontaktierungsbereich zum Anschlusskontaktbereich ausgerichtet vorliegt.

Vorteilhafterweise erlaubt die Bereitstellung des Anschlusskontaktbereiches und des MEMS-Bauteils bzw. der MEMS-Strukturen in der Device-Schicht des Active-Wafers eine funktionsübergreifende Verbindung mit dem Cover-Wafer durch das Bonden. Einerseits wird der interne Bereich des Durchkontaktierungsbereich, der im Cover-Wafer vorliegt, mit dem Anschlusskontaktbereich elektrisch kontaktiert. Andererseits wird das MEMS-Bauteil versiegelt. Dadurch erfüllt ein Prozessschritt zwei Funktionen. Daher ist es auch aus verfahrenstechnischer Sicht von Vorteil, eine interne elektrische Kontaktierung und einen gleichzeitigen hermetischen Abschluss des MEMS-Bauteils zu gewährleisten, um zusätzliche Prozessschritte zu vermeiden.

Durch die höhere Effizienz eignet sich damit das erfindungsgemäße Verfahren insbesondere für Massenproduktion von Halbleiterbauteilen.

In einer weiteren bevorzugten Ausführungsform ist das Verfahren dadurch gekennzeichnet, dass der Active-Wafer ein SOI-Wafer ist, umfassend die Trägerschicht, die mittlere Isolationsschicht und die Device-Schicht und das Unterätzen ein Unterdampfätzen ist für das Freistellen der MEMS-Strukturen für das MEMS-Bauteil und in der Device-Schicht des SOI-Wafers erfolgt.

Vorteilhafterweise kann durch den Einsatz eines SOI-Wafers in Kombination eines gewöhnlichen Wafers als Cover-Wafer eine Kosteneinsparung während der Herstellungsverfahren und damit eine erhöhte Wirtschaftseffizienz resultieren. Darüber hinaus ist es vorteilhaft, dass das Unterdampfätzen besonders prozesseffizient die Isolationsschicht des SOI-Wafers als Active-Wafer ätzen kann. Eine prozesseffiziente Ätzung meint hierbei bevorzugt, dass die Ätzung präzise, schnell und/oder kontrollierbar durchgeführt werden kann. Insbesondere kann vorteilhaft eine optimale Beweglichkeit der MEMS-Strukturen ermöglicht werden, sodass das hierdurch herstellbare MEMS-Bauteil in einer Vielzahl von Anwendungen einsatzfähig ist.

In einer weiteren bevorzugten Ausführungsform ist das Verfahren dadurch gekennzeichnet, dass der Anschlusskontaktbereich in der Device-Schicht des Active-Wafers und der Durchkontaktierungsbereich in der Trägerschicht des Active-Wafers gebildet wird, wobei der Durchkontaktierungsbereich zum Anschlusskontaktbereich ausgerichtet vorliegt.

Bevorzugt kann somit der Durchkontaktierungsbereich in dem Active-Wafer gebildet werden, welcher als Active-Wafer fungiert. Wird der Durchkontaktierungsbereich im Active-Wafer gebildet, befindet sich der Durchkontaktierungsbereich bevorzugt in der Trägerschicht und die Anschlussöffnung in der Device-Schicht des Active-Wafers.

Durch die Anschlussöffnung wird der interne Anschlussbereich des Durchkontaktierungsbereiches elektrisch kontaktiert. Da die Anschlussöffnung mit einem elektrisch leitfähigen Material vollständig oder teilweise befüllt wird, ergibt sich durch eine Auswahl eine flexible Anzahl an Möglichkeiten, um diese zu befüllen. Zudem muss vorteilhafterweise für die interne elektrische Kontaktierung des Durchkontaktierungsbereiches kein zusätzlicher Wafer angebracht werden. Stattdessen liegt in dieser Ausführungsform vorteilhafterweise die interne elektrische Kontaktierung innerhalb eines Wafers, nämlich des Active-Wafers vor, was aus verfahrenstechnischer Sicht entsprechend von Vorteil ist.

Erfindungsgemäß bietet sich damit die Möglichkeit, den Durchkontaktierungsbereich im Active-Wafer oder im Cover-Wafer durch die Bildung von vertikalen Gräben bereitzustellen, welche einen elektrisch leitfähigen Bereich umschließen. Beiden Ausführungsformen des erfindungsgemäßen Herstellungsverfahrens ist gemein, dass sich der interne Anschlussbereich des Durchkontaktierungsbereiches innerhalb der Device-Schicht des Active-Wafers befindet und elektrisch kontaktiert wird über einen Anschlusskontaktbereich oder über eine Anschlussöffnung, welche sich ebenfalls in der Device-Schicht des Active-Wafers befindet. Wird der Durchkontaktierungsbereich im Cover-Wafer gebildet, so wird der Durchkontaktierungsbereich mit dem Anschlusskontaktbereich des Active-Wafers kontaktiert. Wird der Durchkontaktierungsbereich im Active-Wafer gebildet, so wird als interner Anschluss die Anschlussöffnung innerhalb der Device-Schicht mit diesem kontaktiert. Ebenfalls werden in beiden Ausführungsformen die MEMS-Strukturen durch ein Unterätzen mittels dampfförmigen Reaktanten freigestellt, was für eine besonders gute Beweglichkeit der MEMS-Strukturen führt und auch verfahrenstechnisch vorteilhaft ist, da es nicht unerwünschten Oberflächeneffekt hinsichtlich einer Anhaftung kommt.

Für einen hermetischen Einschluss des MEMS-Bauteils innerhalb des Waferstacks werden bevorzugt der Cover-Wafer und der Active-Wafer miteinander gebondet.

Das Bonden von Wafern beschreibt bevorzugt einen Verfahrensschritt in der Halbleiter- und Mikrosystemtechnik, bei dem zwei Wafer oder Scheiben, z. B aus Silizium, Quarz, Glas und/oder den vorgenannten bevorzugten Materialien miteinander verbunden werden.

Beim Bonden können vorzugsweise verschiedene Verfahren zum Einsatz kommen. Diese werden auch als Bondprozesse oder Bondverfahren bezeichnet. Bevorzugte Bondprozesse umfassen direktes Bonden, anodisches Bonden, Bondverfahren mit Zwischenschichten, Glas-Fritt-Bonden, adhäsives Bonden und/oder selektives Bonden.

Beim direkten Bonden, insbesondere von Silizium-Wafern, werden bevorzugt hydrophile und hydrophobe Oberflächen der Wafer unter hohen Temperaturen in Kontakt gebracht. Vorzugsweise wird dabei der eine Wafer mittig gegen den anderen gepresst, wobei vorteilhafterweise ein erster Kontaktpunkt entsteht. Diese mechanische Verbindung im Kontaktbereich beruht dabei vorzugsweise auf Wasserstoffbrücken und/oder Van-der-Waals-Wechselwirkungen. Der somit verbundene Kontaktbereich wird dabei vorzugsweise auf die übrige Waferfläche(n) ausgedehnt, indem anfangs vorhandene Abstandhalter zwischen diesen Flächen sukzessive entfernt werden. Dabei betragen die Prozesstemperaturen vorzugsweise zwischen 1000°C und 1200 C und es wird ein Druck auf die Wafer von beispielsweise der Größenordnung 10 Megapascal (MPa) bis 25 MPa ausgeübt. Das Direkt-Bonden kann vorzugsweise für die Verbindung zweier Silizium-Wafer und/oder Siliziumdioxid-Wafer verwendet werden.

Beim anodischen Bonden findet insbesondere ein Glas mit erhöhter Na⁺-Ionenkonzentration (bevorzugt positiv geladenen Natriumionen) Verwendung, welches bevorzugt mit einem Silizium-Wafer in Kontakt gebracht wird. Dabei wird eine elektrische Spannung angelegt, welche insbesondere konfiguriert ist, eine negative Polung am Glas zu erzeugen. Somit wird bevorzugt und insbesondere mithilfe einer erhöhten Prozesstemperatur erreicht, dass die Natriumionen (Na⁺) zur Elektrode diffundieren, wodurch sich bevorzugt eine Raumladungszone an der Grenzfläche ausbildet, welche eine Erhöhung des elektrischen Feldes bewirkt und Si-O-Si-Bindungen erzeugt. Diese Bindungen weiten sich bevorzugt sukzessive auf die gesamte Verbindungsfläche zwischen Glas und Silizium aus. Somit können insbesondere Glas und Silizium-Wafer miteinander verbunden werden. Bei entsprechender Anpassung des Prozesses ist ebenso ein Bonden zweier Siliziumlagen und/oder einer Silizium-Metall-Lage mit einem Glas möglich. Das anodische Bonden kann vorzugsweise bei Temperaturen von etwa 400° C stattfinden, es kann ebenso bevorzugt bei "Niedrigtemperatur" bei etwa 180° C stattfinden, wobei die zu bondenden Materialien vorzugsweise geschont werden. Bevorzugt können auch verschiedene der vorgenannten Materialien gebondet werden.

Bevorzugt können auch Bond-Verfahren mit sogenannten Zwischenschichten zwischen den zu bondenden Wafern zum Einsatz kommen, wie bspw. das sogenannte Eutektische Bonden, welches vorzugsweise auf der Verbindung durch eine eutektische Legierung als Zwischenschicht, z. B. Si-Au (Silizium-Gold) oder Ge-AI (Germanium-Aluminium), basiert. Eine eutektische Legierung ist vorzugsweise eine Legierung, deren Bestandteile in einem solchen Verhältnis zueinander gemischt sind, dass bei einer bestimmten Temperatur die ganze Legierung flüssig bzw. fest wird. Eutektisches Bonden kann z. B. zum Verbinden zweier Silizium-Wafer verwendet werden. Bevorzugt können jedoch auch andere der vorgenannten Materialien verbunden werden.

Auch das Glas-Fritt-Bonden beruht bevorzugt auf der Verwendung einer Zwischenschicht zwischen den zu verbindenden Wafern, wobei die Verbindungsbildung insbesondere durch Aufschmelzen von Glasloten/Glas-Fritten entsteht. Glaslot umfasst bevorzugt ein Glas, welches eine niedrige Erweichungstemperatur aufweist, bspw. ca. 400°C. Glas-Fritten umfasst bevorzugt oberflächlich geschmolzenes Glaspulver, dessen Glaskörner bevorzugt zumindest teilweise zusammenbacken bzw. -sintern. Diese Art des Bondens kann bevorzugt Silizium- und/oder Siliziumdioxidwafer miteinander verbinden, bevorzugt jedoch auch andere vorgenannte Materialien.

Das adhäsive Bonden beschreibt bevorzugt eine Verbindungsbildung durch eine Zwischenschicht umfassend Klebstoff. Durch adhäsives Bonden können vorzugsweise verschiedene der vorgenannten Materialien miteinander gebonded werden.

Bevorzugt kann durch Photolithographie, Ätzen und/oder Lift-off-Verfahren ein selektives Bonden vorgenommen werden.

Durch das Bonden von Wafern lässt sich besonders einfach ein Halbleiterbauteil herstellen. Das Bonden von Strukturen aus vorbearbeiteten Wafern erlaubt die einfache Herstellung komplexer Strukturen, welche nur mit großem Aufwand aus einem einzelnen Wafer hergestellt werden könnten. Dadurch kann das Halbleiterbauteil hergestellt werden, ohne dass das Rohmaterial aufwendig aus dem Inneren herausgearbeitet werden muss, um beispielsweise eine Kavität innerhalb des Halbleiterbauteils zu erzeugen. Des Weiteren ist der Waferstack zur Bereitstellung des Halbleiterbauteils durch das Bonden fest, robust und zuverlässig gebunden, sodass das Halbleiterbauteil gesamtheitlich und insbesondere das MEMS-Bauteil gut geschützt ist.

In einer weiteren bevorzugten Ausführungsform ist das Verfahren dadurch gekennzeichnet, dass das Freistellen der MEMS-Strukturen durch ein bereichsweises Ätzen der Isolationsschicht des Active-Wafers durch ein Unterätzen, vorzugsweise mittels dampfförmigen Reaktanten erfolgt, wodurch die MEMS-Strukturen bevorzugt translatierbar, rotierbar und/oder schwingfähig werden.

Ein Unterätzen mittels dampfförmigen Reaktanten wird in der Halbleitertechnologie und in der Mikrosystemtechnik häufig verwendet, da es eine Freistellung von MEMS-Strukturen ohne mögliche Verklebungen des Wafers und/oder der MEMS-Strukturen ermöglicht und keine (zeit)aufwendigen Ätzprozesse wie beispielsweise DRIE erfordert. Die Ausdrücke vHF-Unterätzen (vHF für den engl. Ausdruck vapor hydrogen fluoride, deutsch dampfförmiger Hydrogenfluorid ) und Unterdampfätzen können synonym verwendet werden.

Im Stand der Technik sind verschiedene Ansätze und Anlagen bekannt, mit denen ein vHF-Unterätzen angewendet werden kann. Bevorzugt kann beispielsweise ein Verfahren für ein Unterdampfätzen eingesetzt werden, welches in Zhang et al. (2014) beschrieben wird.

In dem zuletzt genannten Paper wird ein Verfahren vorgestellt, um die Passivierungsschicht und die Metallelektroden von MEMS-Bauteilen oder Halbleitersensoren während des Ätzvorgangs effektiv zu schützen. Hierfür wird zunächst ein amorphes Fluorpolymer beschichtet, welches zum Schutz der verbleibenden Komponenten vor dem Unterdampfätzen während des Fertigungsprozesses eingesetzt wird. Das amorphe Fluorpolymer wird durch Rotationsbeschichtung (engl. spincoating) beschichtet. Nach dem Aufbringen einer FotolackMaske werden Abschnitte für ein Trockenätzen bereitgestellt. Nach der Durchführung des Trockenätzens liegen damit MEMS-Strukturen vor. Für die Freistellung der MEMS-Strukturen wird insbesondere Fluorwasserstoff (HF) eingesetzt.

Zur Durchführungen des Unterdampfätzens können verschiedene Unterdampfanlagen eingesetzt werden, beispielsweise kommerziell erhält von SVR^{™} vHF, memsstar Co., Ltd oder vgl. auch WO 2012/101431 A1.

In bevorzugten Ausführungsformen werden die Lösebedingungen und Ätzparameter des Unterdampfätzens optimiert, um eine hohe Ätzrate und damit eine niedrige Ätzzeit zu erreichen, mögliche Beschädigungen zu vermeiden und um sicherzustellen, dass die Mikrostrukturen effektiv und ohne Anhaften freigesetzt werden. Weiterhin kann es auch bevorzugt sein, während des Prozesses Parameter wie Ätztemperatur, Ätzdruck und Durchflussraten von N₂-, HF-und H₂O-Dampf-Injektionen zu optimieren, da auch diese die Ergebnisse des Unterdampfätzens und den gesamtheitlichen Vorgang deutlich beeinflussen.

In einigen Ausführungsformen kann beispielsweise die H₂O-Dampf-Injektionsrate zwischen 0 bis 50 mg/min variieren. Ein Prozessdruck kann beispielsweise 19 Torr, eine Ätztemperatur ca. 20-25°C und Injektionsflussraten für N₂ und HF bei ca. 50-100 sccm, bevorzugt 100 sccm (Standardkubikzentimeter pro Minute) betragen.

Bevorzugt wird durch das Unterdampfätzen eine Oxidschicht und/oder weitere Schichten eines Wafers, insbesondere des Active-Wafers, des Waferstacks und/oder des Halbleiterbauteils entfernt, um vorzugsweise translatierbare, rotierbare und/oder freischwingende MEMS-Strukturen für das MEMS-Bauteil und/oder für eine elektronische Schaltung zu erhalten. Durch die Bewegungsmöglichkeiten der MEMS-Strukturen können vorteilhafterweise vielfältige MEMS-Bauteile hergestellt werden.

MEMS-Strukturen umfassen bevorzugt winzige Bauelemente und/oder Abschnitte eines Wafers, insbesondere eines Active-Wafers, oder eines Waferstacks, die für das MEMS-Bauteil ausgestaltet sind. Sie können bevorzugt mechanische und/oder elektrische Informationen verarbeiten und/oder erzeugen. Bevorzugte MEMS-Strukturen sind für Sensoren und/oder Aktoren, aber auch Oszillatoren und/oder Filter geeignet. Die MEMS-Strukturen können charakteristische Abmaße im Mikrometerbereich (1 µm bis 1000 µm), aber auch kleiner als ein Mikrometer sein, oder sich über mehrere Mikrometer erstrecken. Durch die im Stand der Technik bekannten Möglichkeiten lassen sich MEMS-Strukturen einfach, kostengünstig und massentauglich herstellen.

Translatierbare MEMS-Strukturen bezeichnen bevorzugt eine Bewegungsmöglichkeit, bei der eine MEMS-Struktur eine Translationsbewegung durchführen kann. Hierbei werden bevorzugt alle Punkte einer MEMS-Struktur dieselbe Verschiebung erfahren. Zu einem beliebigen Zeitpunkt sind Geschwindigkeiten und Beschleunigungen aller Punkte der MEMS-Struktur im Wesentlichen identisch. Insbesondere bewegen sich die Punkte einer MEMS-Struktur bei einer Translation auf parallelen Trajektorien. Translatierbare MEMS-Strukturen sind beispielsweise geeignet für Beschleunigungssensoren.

Rotierbare MEMS-Strukturen umfassen bevorzugt die Bewegungsmöglichkeit der MEMS-Struktur eine Rotationsbewegung durchführen zu können. Vorzugsweise kann sich hierbei eine MEMS-Struktur um eine Rotationsachse bewegen. Die Rotationsachse kann, muss aber nicht, durch einen Massenmittelpunkt gehen. Insbesondere bleiben alle Punkte der Rotationsachse an ihrem Ort, während alle anderen Punkte sich in festem Abstand von der Rotationsachse auf einem senkrecht zur Achse liegenden Kreis oder Ellipse um denselben Winkel um sie herumbewegen. Rotierbare MEMS-Strukturen eignen sich beispielsweise für Gyroskope.

Schwingfähige MEMS-Strukturen bezeichnen bevorzugt die Bewegungsmöglichkeit einer MEMS-Struktur, eine Schwingung durchführen zu können. Als Schwingungen werden bevorzugt zeitliche und/oder örtliche Schwankungen eines Punktes einer MEMS-Struktur bezeichnet. Unter Schwankung ist dabei die Abweichung von einem Mittelwert zu verstehen. Schwingungen können mit einem Freiheitsgrad oder mit einer Vielzahl von Freiheitsgraden erfolgen. Insbesondere umfasst eine Schwingung eine mögliche Verformung einer oder mehrerer MEMS-Strukturen, die vorzugsweise mechanische Schwingungen betreffen.

In einer weiteren bevorzugten Ausführungsform ist das Verfahren dadurch gekennzeichnet, dass die MEMS-Strukturen ausgewählt sind aus einer Gruppe umfassend vertikale oder horizontale Lamellen und/oder Mäanderstrukturen umfassend vertikale und horizontale Abschnitte, wobei bevorzugt die Lamellen oder die vertikalen Abschnitte der Mäanderstruktur einen Abstand zueinander bis zu 50 µm, bevorzugt bis zu 10 µm, ganz besonders bevorzugt bis zu ca. 2 µm aufweisen.

Eine Lamellenstruktur bezeichnet bevorzugt eine Anordnung gleichartiger, parallel verlaufender Lagen, welche bevorzugt vertikalen Abschnitte bilden. Die einzelnen Lamellen sind dabei bevorzugt mit ihrer Fläche parallel zur vertikalen Richtung. Es kann dabei bevorzugt sein, dass die Lamellen flächig sind, das bedeutet insbesondere, dass ihre Ausdehnung in jeder der zwei Dimensionen (Höhe, Breite) ihrer Fläche größer ist als in einer hierzu senkrechten Dimension (der Dicke). Beispielsweise können Größenverhältnisse von mindestens 2:1, bevorzugt mindestens 5:1, 10:1 oder mehr bevorzugt sein.

Eine Mäanderstruktur bezeichnet bevorzugt eine aus einer Abfolge zueinander im Wesentlichen orthogonaler Abschnitte im Querschnitt gebildete Struktur. Bei den zueinander orthogonalen Abschnitten handelt es sich bevorzugt um vertikale und horizontale Abschnitte. Die Mäanderstruktur entspricht somit bevorzugt einer entlang der Breite gefalteten Membran. Die Verbindungsabschnitte zwischen den vertikalen Abschnitten bilden bevorzugt die horizontalen Abschnitte. Bevorzugt sind die vertikalen Abschnitte länger als die horizontalen Abschnitte, beispielsweise um einen Faktor ca. 1,5, 2, 3, 4 oder mehr.

In einer weiteren bevorzugten Ausführungsform werden die MEMS-Strukturen in der Device-Schicht des Active-Wafers mit einer Strukturierung oder einem Ätzverfahren bevorzugt einem nasschemischen Ätzverfahren und/oder Trockenätzverfahren, bevorzugt physikalische und/oder chemische Trockenätzverfahren, besonders bevorzugt durch reaktives lonenätzen und/oder reaktives lonentiefätzen (Bosch-Prozess) oder Kombinationen der vorgenannten Ätzverfahren gebildet werden.

Ein Ätzverfahren bezeichnet bevorzugt die Abtragung von Material einer Oberfläche. Synonym kann hierfür auch der Begriff des Ätzprozesses verwendet werden. Die Abtragung kann sich in Form von Vertiefungen veräußern, die Kavitäten an Wafern hinterlassen.

Unter Trockenätzen fasst man in der Halbleitertechnologie und in der Mikrosystemtechnik eine Gruppe von abtragenden Mikrostrukturverfahren zusammen, die nicht auf nasschemischen Reaktionen (wie nasschemisches Ätzen, chemisch-mechanisches Polieren) basieren. Der Materialabtrag erfolgt dabei entweder durch beschleunigte Teilchen oder mithilfe plasmaaktivierter Gase. Es werden also je nach Verfahren chemische sowie physikalische Effekte ausgenutzt.

Trockenätzverfahren lassen sich in drei Gruppen einordnen. Zum einen die physikalischen Trockenätzverfahren, sie basieren auf dem Materialabtrag durch den Beschuss mit Teilchen, zum anderen chemische Trockenätzverfahren, sie basieren auf einer chemischen Reaktion eines meist plasmaaktiverten Gases. Die dritte Gruppe, die physikalisch-chemischen Trockenätzverfahren, fasst Prozesse zusammen, die beide Wirkmechanismen nutzen und ist so in der Lage, die Nachteile der ersten beiden Gruppen zu minimieren.

Beim nasschemischen Ätzen wird eine ätzresistente Maskierung durch einen chemischen Abtragungsprozess in den Wafer übertragen.

Plasmaätzen ist ein materialabtragendes, plasmaunterstütztes Trockenätzverfahren. Beim Plasmaätzen unterscheidet man zwischen einem Ätzabtrag aufgrund einer chemischen Reaktion und einem physikalischen Abtrag der Oberfläche aufgrund von lonenbeschuss.

Beim chemischen Plasmaätzen erfolgt der Materialabtrag durch eine chemische Reaktion. Deshalb ist es im Allgemeinen isotrop und aufgrund des chemischen Charakters auch sehr materialselektiv. Beim physikalischen Plasmaätzen, auch plasmaunterstütztes lonenätzen genannt, handelt es sich um ein physikalisches Verfahren. Bei diesem Verfahren kann eine gewisse Vorzugsrichtung im Ätzangriff entstehen, daher weisen die Verfahren unter Umständen eine Anisotropie im Materialabtrag auf. Beim physikalischen Plasmaätzen werden im Plasma nicht reaktive Ionen erzeugt. Durch ein angelegtes elektrisches Feld werden diese Ionen auf eine Oberfläche beschleunigt und entfernen so Teile der Oberfläche. Dieses Verfahren wird typischerweise zum Entfernen von Oxiden auf Silizium-Wafern verwendet.

Das reaktive lonenätzen (engl. reactive ion etching, RIE) ist ein ionenunterstützter Reaktivätzprozess. RIE ist wegen der guten Kontrollierbarkeit des Ätzverhaltens ein Verfahren zur Herstellung von topografischen Strukturen für die Mikro-, Halbleiter- und Nanosystemtechnologie. Das Verfahren lässt durch chemisch-physikalischen Abtrag sowohl eine isotrope (richtungsunabhängig) als auch eine anisotrope Ätzung zu. Das Ätzen erfolgt durch aufgeladene Teilchen (Ionen), die in einem Gasplasma erzeugt wurden. Eine entsprechende Maskierung (z. B. durch Fotolithografie erzeugt) der Oberfläche gibt die Formgebung der Strukturen.

Reaktives lonentiefenätzen (engl. deep reactive ion etching, DRIE) ist eine Weiterentwicklung des reaktiven lonenätzens (RIE) und ein hoch anisotroper Trockenätzprozess für die Herstellung von Mikrostrukturen in Wafern mit einem Aspektverhältnis von bis zu 50:1, wobei Strukturtiefen von einigen 100 Mikrometern erreicht werden können. Der DRIE-Prozess ist ein zweistufiger, alternierender Trockenätzprozess, bei dem sich Ätz- und Passivierungsschritte abwechseln. Ziel ist es, möglichst anisotrop zu ätzen, das heißt richtungsabhängig, senkrecht zur WaferOberfläche. Auf diese Weise können beispielsweise sehr schmale Gräben geätzt werden.

Die vorgenannten Ätzprozesse sind dem Fachmann bekannt und können vorteilhaft im erfindungsgemäßen Verfahren Anwendung finden. In Abhängigkeit der gewünschten Öffnungen in den bereitgestellten Wafer, können hierbei Verfahren gewählt werden, welche eine besonders effiziente Durchführung gewährleisten.

In einer weiteren bevorzugten Ausführungsform ist das Verfahren dadurch gekennzeichnet, dass das MEMS-Bauteil ein Aktuator und/oder ein Sensor ist, bevorzugt ausgewählt aus einer Gruppe umfassend Beschleunigungssensor, Gyroskop, Drucksensor und/oder Strömungssensor.

MEMS-Bauteile bieten gegenüber konventionellen makroskopischen Systemen vor allem Vorteile in der Kostenersparnis, beispielsweise durch einen deutlich geringeren Verbrauch an Werkstoffen und/oder der parallelen Fertigung von mehreren MEMS-Bauteilen, und in der Effizienz, beispielsweise durch einen geringeren Energie- und Leistungsbedarf. Zudem bieten sie ein großes Funktionsspektrum, hohe Funktionsdichten und neue Funktionalitäten. Die Integration und Miniaturisierung führen zu kurzen Informationswegen und kurzen Reaktionszeiten. Außerdem weisen sie eine höhere Zuverlässigkeit auf als konventionelle Systeme, vor allem durch den Wegfall von Steckern und Kabeln oder fehleranfälligen und feinmechanischen Elementen.

Ein MEMS-Bauteil umfasst bevorzugt ein miniaturisiertes Gerät, eine Baugruppe und/oder ein Bauteil, dessen Komponenten charakteristische Abmessungen im µm-Bereich (bevorzugt kleiner als 1000 µm) haben und als System zusammenwirken. Der Einsatz von MEMS-Bauteilen ist überall dort denkbar und nach Anwendungsfall sinnvoll, wo Sensoren/Aktoren und Elektronik zusammenarbeiten.

Ein Beschleunigungssensor misst in der Regel mit einer Positionsmessschaltung die Verschiebung einer Prüfmasse. Für die digitale Weiterverarbeitung wird das gemessene Signal beispielsweise mithilfe eines A/D-Wandlers in eine digitale Information umgewandelt. Da die Beschleunigung der Prüfmasse direkt proportional zu der auf den Körper wirkenden Kraft ist, kann die Beschleunigung indirekt über eine Kraft gemessen werden, die auf eine der Achsen des Beschleunigungssensors wirkt. Beschleunigungssensoren umfassen vorzugsweise Bohrungen, Hohlräume, Federn und Kanäle, die mithilfe von im Stand der Technik bekannten Mikrobearbeitungsverfahren angefertigt werden können. Die Beschleunigungskräfte können anhand der Verschiebung der Prüfmasse in Bezug auf feststehende Elektroden gemessen werden.

Ein verbreitetes Messverfahren, das in Beschleunigungssensoren zum Einsatz kommt, ist kapazitiver Natur. Die Beschleunigung wird dabei als Kapazitätsänderung der beweglichen Prüfmasse erfasst. Typisch für diese Technik sind ihre hohe Genauigkeit und Stabilität, die geringe Verlustleistung und die einfach herzustellende Struktur. Ihre Anfälligkeit gegenüber Rauschen und Temperaturschwankungen ist gering. Die durch Beschleunigung hervorgerufene, im Mikrometerbereich liegende Verschiebung der beweglichen Masse bewirkt eine geringe Kapazitätsänderung, die es zu erfassen gilt. Dies bedingt die Verwendung einer großen Zahl beweglicher Massen und feststehender Elektroden, die bevorzugt parallelgeschaltet werden. Diese Anordnung ergibt eine höhere Kapazitätsänderung, die sich präziser erfassen lässt.

Gyroskope sind Bauteile, die Drehbewegungen messen oder beibehalten. Sie sind kompakte, kostengünstige Sensoren, die die Winkelgeschwindigkeit messen. Die Einheiten der Winkelgeschwindigkeit werden in Grad pro Sekunde (°/s) oder Umdrehungen pro Sekunde (RPS, engl. rounds per seconds) gemessen. Gyroskope können zur Bestimmung der Orientierung verwendet werden und sind in den meisten autonomen Navigationssystemen zu finden. Bei einer Rotation wird eine kleine Prüfmasse verschoben, wenn sich die Winkelgeschwindigkeit ändert. Diese Bewegung wird in sehr schwache elektrische Signale umgewandelt, die beispielsweise von einem Mikrocontroller verstärkt und gelesen werden können. Das Funktionsprinzip vieler bekannter Gyroskope ist, wie im obigen Abschnitt zu Beschleunigungssensoren aufgeführt, kapazitiver Natur.

Drucksensoren umfassen beispielsweise auf einem Wafer oder einem Mikrochip angebrachte Kondensatoren, die zum Beispiel über die MEMS-Strukturen gebildet werden können. Bei einer Druckbeaufschlagung werden die Abstände der MEMS-Strukturen und damit auch die Kapazitäten verändert. Dieses Funktionsprinzip ist ebenfalls kapazitiv. Allerdings können Drucksensoren auch auf anderen physikalischen Prinzipien beruhen. So ist der Einsatz von beispielsweise induktiven Drucksensoren, piezoresistiven Drucksensoren oder auch Drucksensoren, welche auf den Hall-Effekt basieren, möglich.

Strömungssensoren dienen zur Erfassung des Durchflusses von Fluidströmungen. Strömungssensoren können auf thermische und auf nicht-thermische Prinzipien beruhen. Die im Stand der Technik am häufigsten vorkommenden nicht-thermischen Strömungssensoren sind die sogenannten Drag Force Sensoren, Pressure Drop Sensoren und/oder Coriolis Sensoren. Das thermische Prinzip basiert bevorzugt auf der konvektiven Wärmeübertragung eines elektrisch beheizten Widerstandes in das vorbeiströmende Fluid, welche in Abhängigkeit der Flussrate zum Abkühlen des Heizers führt und somit elektrisch erfasst werden kann. Da der konvektive Wärmetransport direkt proportional zum Massenfluss ist, handelt es sich bei diesen Sensoren um Massenflusssensoren. Es gibt prinzipiell drei verschiedene Arten von Strömungssensoren, nämlich Hitzdraht- bzw. Heißfilmsensoren (thermische Anemometer), Kalorimetrische Sensoren und Time-of-Flight Sensoren.

In einer weiteren bevorzugten Ausführungsform ist das Verfahren dadurch gekennzeichnet, dass das Halbleiterbauteil mit einem MEMS-Bauteil und/oder einer elektronischen Schaltung mittels einer Die-Attach-Technologie, Flip-Chip-Technologie, Durchsteckmontage, Oberflächenmontage, Bondtechnologie, Laserschweißen, Heißsiegeltechnologie, Fügeprozessen, Kleben und/oder Löten verbunden wird.

Die genannten Verbindungs- und Montagetechniken haben sich im Stand der Technik als besonders zuverlässig, robust und einfach herausgestellt. Insbesondere können elektronische und nichtelektronische (Mikro-)Komponenten miteinander besonders gut, robust und zuverlässig verknüpft werden.

In einer weiteren bevorzugten Ausführungsform ist das Verfahren dadurch gekennzeichnet, dass die vertikalen Gräben, die den Durchkontaktierungsbereich für eine Isolierung umschließen, durch nasschemische Ätzverfahren und/oder Trockenätzverfahren, bevorzugt durch physikalische und/oder chemische Trockenätzverfahren, besonders bevorzugt durch reaktives lonenätzen und/oder reaktives lonentiefätzen (Bosch-Prozess) gebildet werden.

In einer weiteren bevorzugten Ausführungsform ist das Verfahren dadurch gekennzeichnet, dass die vertikalen Gräben eine Tiefe von im Wesentlichen 100 µm, bevorzugt im Wesentlichen 50 µm, und eine Breite von im Wesentlichen 5 µm, bevorzugt im Wesentlichen 2 µm, aufweisen.

In einer weiteren bevorzugten Ausführungsform ist das Verfahren dadurch gekennzeichnet, dass die vertikalen Gräben zur Isolierung des Durchkontaktierungsbereiches mit einem ersten Verfüllmaterial partiell oder vollständig befüllt und verschlossen werden, wobei das erste Verfüllmaterial ein Dielektrikum oder ein elektrisch leitfähiges Material ist, wobei bei der Befüllung mit dem elektrisch leitfähigen Material eine Auskleidung der vertikalen Gräben mit einem Dielektrikum erfolgt.

Nach der Bildung der vertikalen Gräben weisen diese bevorzugt eine Öffnung auf. Damit weisen sie insbesondere auch Seitenwände und einen Boden auf. Das Auskleiden der vertikalen Gräben umfasst das Beschichten der Seitenwände und/oder des Bodens der vertikalen Gräben mit dem Dielektrikum. Eine partielle Befüllung der vertikalen Gräben umfasst das Auskleiden der vertikalen Gräben. Dies kann durch bestimmte Beschichtungsprozesse erfolgen, die in der Mikrosystemtechnik bekannt und geläufig sind, wie beispielsweise die thermische Oxidation von Silizium.

Es hat sich als besonders vorteilhaft erwiesen, dass durch das Auskleiden und der partiellen Befüllung der vertikalen Gräben mit einem Dielektrikum besonders niedrige parasitäre Kapazitäten auftreten. Dies lässt sich damit erklären, dass die Material- und damit die Dipoldichte verringert wird. Insbesondere wird durch eine partielle Befüllung freies Volumen geschaffen, sodass relative Permittivität verringert wird und damit auch die parasitäre Kapazität.

Die parasitären Kapazitäten können horizontal und/oder vertikal zwischen dem Durchkontaktierungsbereich und weiteren Bereichen des Wafers und/oder des Halbleiterbauteils vorliegen. Vor allem jedoch können sich parasitäre Kapazitäten zwischen zwei Durchkontaktierungen bilden, die nebeneinander verlaufen. Fließt Strom und/oder liegt eine Spannung am Durchkontaktierungsbereich an, bilden sich elektrische und/oder magnetische Felder zwischen dem Durchkontaktierungsbereich und horizontalen und/oder vertikalen Bereichen des Wafers und/oder des Halbleiterbauteils. Durch eine Befüllung der vertikalen Gräben mit einem Dielektrikum wird insbesondere das elektrische Feld geschwächt, denn durch die Polarisation im Dielektrikum entsteht ein entgegengesetztes elektrisches Feld. Daher endet ein Teil der Feldlinien des elektrischen Feldes in den Polarisationsladungen an der Oberfläche des Dielektrikums.

Parasitäre Kapazitäten entstehen beispielsweise, wenn zwei Leiterbahnen sich auf unterschiedlichen Ebenen kreuzen und/oder wenn zwei Leiterbahnen parallel nebeneinander verlaufen. Der Kreuzungsbereich bzw. die benachbarten Leitbahnen, zwischen denen parasitäre Kapazitäten auftreten, können in einer ersten Näherung mit einem üblichen Plattenkondensator modelliert werden

Eine vollständige Befüllung der vertikalen Gräben führt vorteilhafterweise zu einer besonders robusten und stabilen elektrischen Isolierung des Durchkontaktierungsbereiches. Ebenso führt eine vollständige Befüllung der vertikalen Gräben zu einer besonders guten mechanischen Stabilisierung des Durchkontaktierungsbereiches. Dadurch ergibt sich ein besserer Halt und eine zuverlässigere elektrische Verbindung.

Auch eine vollständige Befüllung der vertikalen Gräben kann bevorzugt zur Verringerung der parasitären Kapazität führen, beispielsweise durch die Beschichtung von porösem dielektrischen Material, um freies Volumen bzw. eine Verringerung der Dipoldichte zu erreichen. Bei einer vollständigen Befüllung der vertikalen Gräben können die auftretenden parasitären Kapazitäten ebenfalls verringert werden. Insbesondere kann dies durch das eben beschriebene physikalische Prinzip erfolgen, dass freies Volumen geschaffen wird. Dies kann insbesondere dadurch bewerkstelligt werden, indem das Verfüllmaterial porös ist. Auch poröses Material schafft freies Volumen durch die Bereitstellung lokal begrenzter Poren.

Eine Verringerung der parasitären Kapazitäten durch eine vollständige Befüllung der vertikalen Gräben kann erreicht werden, indem die Polarisierbarkeit des eingesetzten Verfüllmaterials gesenkt wird. Dies kann durch den Einsatz von Verfüllmaterial erlangt werden, welches geringe polare Bindungen aufweist. Dies ist der Fall, wenn die beteiligten Atome eine im Wesentlichen gleiche oder ähnliche Elektronegativität aufweisen. Beispielsweise kann dies durch eine Bindung umfassend Kohlenstoff-Kohlenstoff (C-C) realisiert werden. Möglich sind auch Bindungen umfassend Kohlenstoff-Wasserstoff (C-H), Silizium-Kohlenstoff (Si-C) und/oder Silizium-Fluor (Si-F).

Auch weitere Materialien wie Siliziumnitrid, Tetraethylorthosilicat (TEOS), Siliziumoxinitrid und/oder Siliziumdioxid können als erstes Verfüllmaterial, d.h. zur Befüllung der vertikalen Gräben, eingesetzt werden.

Zudem werden bevorzugt die vertikalen Gräben durch das Dielektrikum verschlossen, sodass diese hermetisch abgeriegelt sind. Vorteilhafterweise werden dadurch geringste Kontaminationen der vertikalen Gräben durch ein Fluid, wie beispielsweise Luft und/oder Wasser, die die Funktion des Halbleiterbauteils beeinträchtigen könnten, verhindert. Bevorzugt erfolgt das Verschließen der vertikalen Gräben, indem die Öffnung der vertikalen Gräben verschlossen werden.

Ebenfalls kann es bevorzugt sein, dass das erste Verfüllmaterial zur Befüllung der vertikalen Gräben neben dem Dielektrikum auch ein elektrisch leitfähiges Material umfasst. Beim Einsatz von elektrisch leitfähigen Materialien ist es bevorzugt, dass die vertikalen Gräben zunächst mit einem Dielektrikum partiell und anschließend mit dem elektrisch leitfähigen Material befüllt werden.

In einer weiteren bevorzugten Ausführungsform ist das Verfahren dadurch gekennzeichnet, dass die vertikalen Gräben mit einem Dielektrikum planar verschlossen werden und/oder die vertikalen Gräben durch eine Auskleidung mit dem Dielektrikum hermetisch verschlossen werden und/oder zum hermetischen Verschließen zusätzlich eine Siegelschicht aufgebracht wird. Das erste Verfüllmaterial umfasst hierbei das Dielektrikum und die Siegelschicht.

Das planare Verschließen der vertikalen Gräben mit einem Dielektrikum hat sich in mindestens zwei Aspekten als vorteilhaft erwiesen. Zum einen erlangen die vertikalen Gräben mit dem planaren Verschluss durch ein Dielektrikum einen besonders guten hermetischen Verschluss, zum anderen ist es nach dem planaren Verschluss besonders einfach, weitere planare Prozesse des Verfahrens während der Herstellung durchzuführen. Ein solcher planarer Prozess kann insbesondere ein Planarisieren von Wafern sein. Dadurch, dass z. B. Leiterbahnen ein gewisses strukturelles Muster auf der Oberfläche des Wafers erzeugen, kommt es zu störenden Unebenheiten (z. B. Störung der Lithografie durch Schrägreflexion, Ungleichmäßigkeiten in folgenden Abscheidungen). Daher wird insbesondere an mehreren Stellen im Fertigungsablauf der Wafer erneut planarisiert. Das kann beispielsweise durch selektives Zurückätzen oder durch chemisch-mechanisches Polieren (CMP) erfolgen. Nicht nur das Polieren hinterlässt Partikel auf der Oberfläche, die für den nächsten Lithografieschritt völlig rein und eben sein muss. Auch z. B. Ätzprozesse hinterlassen Rückstände von unerwünschten Reaktionsprodukten. Im ersten Fall werden die Wafer mechanisch durch Bürsten und einem Ultraschallbad gereinigt, im zweiten Fall durch nasschemische Verfahren und ebenfalls im Ultraschallbad. Um besonders einfach zusätzliche planare Prozesse auf dem Wafer und/oder auf dem Waferstack durchzuführen, hat es sich als Vorteil erwiesen, dass die vertikalen Gräben planar mit einem Dielektrikum verschlossen werden.

Ein planares Verschließen der vertikalen Gräben bezeichnet insbesondere eine Beschichtung des Wafers mit einem Dielektrikum, wobei sich das Dielektrikum im Wesentlichen entlang der Ebene des Wafers erstreckt, an denen die vertikalen Gräben ausgebildet sind.

Die eben aufgeführten Materialien und Möglichkeiten der Befüllung der vertikalen Gräben können gleichermaßen für die Trenngräben erfolgen. Darüber hinaus kann es bevorzugt sein, die Trenngräben ungefüllt zu belassen.

Das Dielektrikum zum Befüllen und/oder Auskleiden der vertikalen Gräben für das erste Verfüllmaterial und/oder die Siegelschicht Siliziumnitrid, Tetraethylorthosilicat (TEOS), Siliziumoxinitrid und/oder Siliziumdioxid umfasst.

Die genannten Materialien sind besonders einfach und kostengünstig zu bearbeiten und eignen sich hervorragend für eine Massenanfertigung. Diese Materialien sind auch besonders gut für ein Bearbeiten und/oder Beschichten geeignet, um einen optimalen hermetischen Verschluss der vertikalen Gräben zu bilden. Erfindungsgemäß wird bevorzugt für einen besonders guten hermetischen Verschluss eine Siegelschicht angebracht, mit der die vertikalen Gräben partiell befüllt und/oder an die Seitenwände und den Boden zusätzlich zum Dielektrikum angebracht werden. Die genannten Materialien bieten große Vorteile, welche aufgrund der Verwendung von standardisierten Herstellungstechniken für eine Beschichtung und Befüllung der vertikalen Gräben gut geeignet sind.

Das Befüllen, das Auskleiden und/oder das Verschließen der vertikalen Gräben und/oder der Trenngräben geschieht vorzugsweise über im Stand der Technik bekannte Beschichtungsverfahren. Vorzugsweise erfolgt die Beschichtung durch ein Beschichtungsverfahren innerhalb einer Beschichtungsanlage, bevorzugt durch eine Sprühbeschichtung, Nebelbeschichtung und/oder Dampfbeschichtung.

Eine Sprühbeschichtung bezeichnet insbesondere ein flächiges Aufbringen eines Dielektrikums, wobei das Dielektrikum vor dem Sprühen vorzugsweise unter Druck gestellt wird (z. B. größer als der vorherrschende Umgebungsdruck), sodass feine Partikel/Aerosole des Dielektrikums und/oder ein Schaum entstehen. Dadurch kann eine besonders feine Beschichtung erreicht werden, welche alle besprühten Bereiche bedeckt, auch wenn diese beispielsweise Flächen aufweisen, welche gegenüber der Sprührichtung in einem ungünstigen Winkel liegen. Auch zueinander abgewinkelte Flächen/Bereiche können so bevorzugt unmittelbar bedeckt werden.

Bevorzugt wird hierfür ein flüssiges Dielektrikum unter gegenüber der Umgebung erhöhten Druck zerstäubt und flächig aufgebracht.

Die Sprühbeschichtung ist vorzugsweise eine Sprühbelackung. Die Sprühbeschichtung kann auch eine Gasphasenabscheidung sein.

Eine Nebelbeschichtung umfasst vorzugsweise eine Beschichtung durch feine Tröpfchen des Dielektrikums, welche in einer Atmosphäre (bevorzugt ein Gas) fein verteilt sind. Eine Dampfbeschichtung erfolgt vorzugsweise durch ein aufzutragendes Dielektrikum in Dampfform, bzw. gasförmig.

Vorzugsweise erfolgt die Beschichtung über eine Beschichtungsanlage, die eine physikalische Beschichtungsanlage oder chemische Beschichtungsanlage, bevorzugt plasmagestützte chemische Beschichtungsanlage, Niederdruck-chemische und/oder Epitaxie-Beschichtungsanlage sein kann.

Eine physikalische Beschichtungsanlage bezeichnet bevorzugt eine Beschichtungsanlage, die die Beschichtung durch die physikalische Gasphasenabscheidung durchführt. Die physikalische Gasphasenabscheidung (engl. physical vapour deposition, PVD), selten auch physikalische Dampfphasenabscheidung, bezeichnet eine Gruppe von vakuumbasierten Beschichtungsverfahren bzw. Dünnschichttechnologien. Anders als bei Verfahren der chemischen Gasphasenabscheidung wird mithilfe physikalischer Verfahren das Ausgangsmaterial in die Gasphase überführt. Das gasförmige Material wird anschließend zum zu beschichtenden Wafer geführt, wo es kondensiert und die Zielschicht bildet.

Eine Epitaxie-Beschichtungsanlage bezeichnet bevorzugt eine Anlage, worin ein Epitaxie-Verfahren angewendet wird, bevorzugt die Molekularstrahlepitaxie. Die Molekularstrahlepitaxie (engl. molecular beam epitaxy, MBE) ist ein Verfahren der physikalischen Gasphasenabscheidung (PVD), um kristalline dünne Schichten (bzw. Schichtsysteme) herzustellen. Epitaxie bedeutet, dass die Kristallstruktur der aufwachsenden Schicht sich der des Substrates anpasst, solange die physikalischen Eigenschaften der beiden Substanzen nicht zu stark voneinander abweichen.

Das Sputtern (von engl. to sputter = zerstäuben), auch Kathodenzerstäubung genannt, ist ein physikalischer Vorgang, bei dem Atome aus einem Festkörper (Target) durch Beschuss mit energiereichen Ionen (vorzugsweise Edelgasionen) herausgelöst werden und in die Gasphase übergehen.

Auch eine Beschichtung mithilfe einer galvanischen Abscheidung (auch als Galvanotechnik oder Galvanik) kann bevorzugt sein. Die galvanische Abscheidung bezeichnet bevorzugt die elektrochemische Abscheidung materieller Niederschläge, also von Überzügen auf Wafern in einem elektrolytischen Bad.

Eine chemische Beschichtungsanlage bezeichnet bevorzugt eine Beschichtungsanlage, die über die chemische Gasphasenabscheidung Beschichtungen durchführt. Bei der chemischen Gasphasenabscheidung (engl. chemical vapour deposition, CVD) wird an der erhitzten Oberfläche eines Wafers aufgrund einer chemischen Reaktion aus der Gasphase eine Feststoffkomponente abgeschieden. Eine besondere Eigenschaft des Verfahrens ist die konforme Schichtabscheidung, wodurch auch z. B. feinste Vertiefungen in Wafern gleichmäßig beschichtet werden. Umfasst von der chemischen Gasphasenabscheidung ist auch die Atomlagenabscheidung (engl. atomic layer deposition, ALD).

Die plasmagestützte chemische Beschichtungsanlage bezeichnet bevorzugt eine Anlage, die das Verfahren der plasmagestützten oder plasmaunterstützten chemischen Gasphasenabscheidung nutzt (engl. plasma-enhanced chemical vapour deposition, PECVD; auch engl. plasma-assisted chemical vapour deposition, PACVD, genannt). Das Plasma kann direkt beim zu beschichtenden Wafer (Direktplasma-Methode) oder in einer getrennten Kammer (Remote-Plasma-Methode) brennen. Während bei der CVD die Dissoziation der Moleküle des Gases durch externe Zufuhr von Wärme sowie die freigewordene Energie der folgenden chemischen Reaktionen geschieht, übernehmen diese Aufgabe bei der PECVD beschleunigte Elektronen im Plasma. Zusätzlich zu den auf diese Weise gebildeten Radikalen werden in einem Plasma auch Ionen erzeugt, die zusammen mit den Radikalen die Schichtabscheidung auf dem Wafer bewirken. Die Gastemperatur im Plasma erhöht sich dabei in der Regel um wenige Hundert Grad Celsius, wodurch im Gegensatz zur CVD auch temperaturempfindlichere Materialien beschichtet werden können. Bei der Direktplasma-Methode wird zwischen dem zu beschichtenden Wafer und einer Gegenelektrode ein starkes elektrisches Feld angelegt, durch das ein Plasma gezündet wird. Bei der Remote-Plasma-Methode ist das Plasma so angeordnet, dass es keinen direkten Kontakt zum Substrat hat. Dadurch erzielt man Vorteile bzgl. selektiver Anregung von einzelnen Komponenten eines Prozessgasgemisches und verringert die Möglichkeit einer Plasmaschädigung der Waferoberfläche durch die Ionen.

Niederdruck-CVD (engl. low pressure chemical vapour deposition, LPCVD) ist ein in der Halbleitertechnologie häufig eingesetztes Verfahren zur Abscheidung von Siliziumoxid, Siliziumnitrid und Polysilizium, sowie von Metallen.

Weiterhin ist es bevorzugt, dass eine Anschlussöffnung gebildet wird, die mit einem Leitermaterial vollständig oder teilweise befüllt wird. Durch die Anschlussöffnung wird eine vorzugsweise interne elektrische Verbindung zum Durchkontaktierungsbereich bereitgestellt. Die Anschlussöffnung kann dabei in einem Wafer und/oder einem Waferstack gebildet werden. Bevorzugt wird die Anschlussöffnung in der Device-Schicht des SOI-Wafers als Active-Wafer gebildet und befindet sich in derselben Schicht wie das MEMS-Bauteil. Zur Bildung der Anschlussöffnung können beispielsweise Ätzverfahren eingesetzt werden. Darüber kann es bevorzugt sein, dass die Anschlussöffnung in den Durchkontaktierungsbereich hineinreicht. Für die elektrische Kontaktierung wird die Anschlussöffnung mit einem elektrisch leitfähigen Material, wie beispielsweise Polysilizium, befüllt.

Es kann bevorzugt sein, dass der Durchkontaktierungsbereich im Cover-Wafer gebildet wird. Hierbei ist es dann bevorzugt, dass die vertikalen Gräben ebenfalls in dem Cover-Wafer gebildet werden, um den Durchkontaktierungsbereich im Cover-Wafer bereitzustellen. Bei der Bildung des Durchkontaktierungsbereiches in dem Cover-Wafer wird vorzugsweise der Durchkontaktierungsbereich mit dem Anschlusskontaktbereich des Active-Wafers kontaktiert.

Es hat sich als bevorzugt herausgestellt, dass die vertikalen Gräben im Wesentlichen ein Aspektverhältnis bis zu 50:1 und/oder im Wesentlichen eine Tiefe zwischen 100 µm und 1000 µm aufweisen. Das Aspektverhältnis von Höhe zu Breite kann insbesondere von 15:1 bis 50:1 reichen. In weiteren Ausführungsformen kann die Tiefe von 1 µm bis einem oder mehreren Millimetern reichen. Ein Beispiel bildet ein Aspektverhältnis von ca. 30:1 mit der Tiefe zwischen 10 µm und 200 µm. Die genannten Aspektverhältnisse haben sich dahingehend als vorteilhaft herausgestellt, dass die mechanischen Spannungen innerhalb des Wafers, des Waferstacks und/oder des Halbleiterbauteils selbst zu einem Verzug nahe Null führen.

Die genannten Aspektverhältnisse sind auch dahingehend vorteilhaft, dass ein Innenraum der vertikalen Gräben sich besonders einfach durch die im Stand der Technik bekannten und zuverlässigen Beschichtungsverfahren mit dem ersten Verfüllmaterial, umfassend ein Dielektrikum, befüllen lässt. Insbesondere in Bezug auf die laterale Ausbreitung der Öffnung der vertikalen Gräben eignen sich die genannten Aspektverhältnisse für eine konforme Abscheidung eines Dielektrikums, durch welche sich diese sehr einfach und besonders gut verschließen lassen. Damit werden die vertikalen Gräben hermetisch abgeriegelt, sodass ein Stoffaustausch mit der Umgebung des Wafers, des Waferstacks und/oder des Halbleiterbauteils verhindert wird.

Als Aspektverhältnis (engl. aspect ratio) bezeichnet man bevorzugt das Verhältnis aus der Tiefe bzw. Höhe zu ihrer lateralen Ausdehnung. Wird beispielsweise durch ein Ätzverfahren in einem Silizium-Wafer ein 40 µm breiter, beliebig langer und 100 µm tiefer Graben erzeugt, so hat dieser Graben das Aspektverhältnis 2,5:1. Solche Aspektverhältnisse größer als 1 erfordern den Einsatz von anisotropen Strukturierungsmethoden, beispielsweise das reaktive lonenätzen (RIE). Bei monokristallinen Wafern, wie beispielsweise Silizium-Wafern, können durch anisotropes Ätzen, beispielsweise mit Kalilauge, auch nasschemisch Strukturen mit hohem Aspektverhältnis erzeugt werden.

In einer weiteren bevorzugten Ausführungsform ist das Verfahren dadurch gekennzeichnet, dass der Cover-Wafer oder der Active-Wafer durch Schleifverfahren, bevorzugt durch Grinding, und/oder durch Polierverfahren, bevorzugt durch chemisch-mechanisches Polieren, zu einer Regulierung von Ausmaßen und/oder einer Glättung des Halbleiterbauteils, bearbeitet wird.

Die aufgezählten Verfahren zum Schleifen eines Wafers haben sich in der Halbleitertechnologie bewährt, Oberflächen mit hoher Präzision zu planarisieren und zu glätten. Planare und sehr glatte Oberflächen sind bevorzugte Vorbedingungen für weitere Prozessschritte, wie beispielsweise für Photolithographieprozesse oder Bonden bei der Herstellung von modernen integrierten Schaltungen (ICs), da die Erstellung von Strukturen mit kleinsten Breiten, Längen und/oder Dicken nur auf sehr ebenen Oberflächen möglich sind. Heutige ICs mit mehreren Verdrahtungsebenen und kleinsten Linienbreiten werden daher bevorzugt mit einer hochfertigen Qualität auf sehr glatten und ebenen Flächen angefertigt.

Das Grinding bezeichnet bevorzugt einen Fertigungsschritt bei der Herstellung von Halbleiterbauteilen, bei dem die Dicke der Wafer reduziert wird, um das Stapeln und hochdichte Verpacken von ICs zu ermöglichen. Vor dem Grinding werden die Wafer üblicherweise mit UVhärtbarem Rückschleifband laminiert, das eine Beschädigung der Waferoberfläche während des Rückschleifens verhindert und eine Verunreinigung der Waferoberfläche durch das Eindringen von Schleifflüssigkeit und/oder Ablagerungen verhindert. Die Wafer werden während des gesamten Prozesses mit deionisiertem (demineralisiertem) Wasser gewaschen, was ebenfalls zur Vermeidung von Verunreinigungen beiträgt.

Beim chemisch-mechanischen Polieren, auch chemisch-mechanisches Planarisieren (CMP, engl. chemical mechanical polishing, auch chemical mechanical planarization) werden dünne Schichten auf einem Wafer gleichmäßig abgetragen. Der zu polierende Wafer wird von einem Waferträger (Carrier) aufgenommen und mit einem definierten Druck auf einen Polierteller mit einem Poliertuch gepresst. Währenddessen beginnen sich Waferträger und Poliertuch in dieselbe Richtung zu drehen, wobei auch eine ungleichsinnige Drehrichtung möglich ist. Hier gibt es verschiedenste Möglichkeiten, die Geschwindigkeiten zu variieren oder den Waferträger in eine oszillierende Bewegung zu versetzen, um so den Abtrag und dessen Gleichmäßigkeit zu optimieren.

In einer weiteren bevorzugten Ausführungsform ist das Verfahren dadurch gekennzeichnet, dass auf dem Durchkontaktierungsbereich ein Anschlusspad angebracht wird, wobei zu diesem Zweck bevorzugt zunächst eine Isolierschicht unter zumindest teilweisem Auslassen des Durchkontaktierungsbereiches auf den Cover-Wafer oder den Active-Wafer aufgebracht wird und durch Füllen des ausgelassenen Bereiches mit einem leitfähigen Material das Anschlusspad gebildet wird.

Durch die Bildung des Anschlusspads wird ein externer Anschlussbereich zur elektrischen Verbindung des Durchkontaktierungsbereiches bereitgestellt, um einen geschlossenen Stromkreis für den Betrieb des MEMS-Bauteils zu ermöglichen. Vorzugsweise wird der Anschlusspad dadurch gebildet, dass zunächst eine Isolierschicht auf eine Kontaktierungsseite des Wafers aufgetragen wird. Dabei wird die Isolierschicht bevorzugt derart beschichtet, dass der räumlich laterale Bereich des Durchkontaktierungsbereiches nicht beschichtet wird.

Es kann auch bevorzugt sein, die Kontaktierungsseite des Wafers und/oder des Waferstacks im Wesentlichen vollständig mit der Isolierschicht zu beschichten und dann anschließend im Bereich des Durchkontaktierungsbereiches zu strukturieren. Durch die Strukturierung soll die Isolierschicht im Bereich des Durchkontaktierungsbereiches entfernt werden. Damit wird eine Möglichkeit geschaffen, einen externen Anschlussbereich des Durchkontaktierungsbereiches elektrisch zu kontaktieren. Hierbei gebildete Strukturen können Ecken, Kanten, Vertiefungen, Senken und/oder Löcher umfassen. Durch die Isolierschicht bzw. durch das Strukturieren der Isolierschicht am Durchkontaktierungsbereich wird eine gezielte elektrische Kontaktierung mit diesem ermöglicht. Insbesondere verhindert die Isolierschicht einen elektrischen Kontakt zwischen dem Anschlusspad und anderen Bereichen des Wafers und/oder Waferstacks, sodass Kurzschlüsse vermieden werden.

Durch Ausfüllen der ausgelassenen Stelle des Durchkontaktierungsbereiches mit einem elektrisch leitfähigen Material wird ein Anschlusspad gebildet, sodass der Durchkontaktierungsbereich auch von dem zweiten Anschlussbereich, der externe Anschlussbereich, elektrisch kontaktiert werden kann. Der Anschlusspad dient bevorzugt dazu, mit dem Durchkontaktierungsbereich eine elektrische Verbindung herzustellen. Damit wird es ermöglicht, einen Stromkreis zu schließen, um das MEMS-Bauteil zu betreiben.

In einer weiteren bevorzugten Ausführungsform ist das Verfahren dadurch gekennzeichnet, dass der Durchkontaktierungsbereich zwischen den vertikalen Gräben entfernt und mit einem Metall, bevorzugt Kupfer, Aluminium, Eisen, Zink, Zinn, Wolfram, Gold, deren Verbindungen und/oder Legierungen, befüllt wird.

Vorzugsweise erfolgt das Entfernen des Wafermaterials im Durchkontaktierungsbereich durch eines der oben dargestellten Ätzverfahren und das Befüllen des Durchkontaktierungsbereiches mit den genannten Materialien durch die beschrieben Beschichtungsverfahren, wobei hier das Sputtern und/oder die galvanische Abscheidung besonders bevorzugt sind.

Die genannten Materialien haben sich im Stand der Technik als sehr gute und zuverlässige elektrische Leitermaterialien bestätigt und können einfach und schnell mit den bekannten Beschichtungsmethoden in den Durchkontaktierungsbereich hineingeführt werden. Insbesondere weisen die genannten Materialien einen geringen spezifischen Widerstand auf, sodass der Strom besonders gut geleitet wird.

In einer weiteren bevorzugten Ausführungsform ist das Verfahren dadurch gekennzeichnet, dass der Anschlusskontaktbereich in der Device-Schicht des Active-Wafers durch die Bildung von Trenngräben gebildet wird, wobei innerhalb der Trenngräben Vakuum vorliegt oder die Trenngräben mit einem zweiten Verfüllmaterial befüllt werden.

Das zweite Verfüllmaterial umfasst vorzugsweise ebenfalls ein Dielektrikum. Das zweite Dielektrikum kann auch leitfähiges Material umfassen. Wird elektrisch leitfähiges Material für das zweite Verfüllmaterial eingesetzt, werden die Trenngräben mit einem Dielektrikum ausgekleidet, um insbesondere einen Kurzschluss zu vermeiden.

In einer weiteren bevorzugten Ausführungsform ist das Verfahren dadurch gekennzeichnet, dass die Trenngräben eine Tiefe von im Wesentlichen 100 µm, bevorzugt im Wesentlichen 50 µm, und eine Breite von im Wesentlichen 5 µm, bevorzugt im Wesentlichen 2 µm, aufweisen.

In einer weiteren bevorzugten Ausführungsform ist das Verfahren dadurch gekennzeichnet, dass die Anschlussöffnung zur Bereitstellung der elektrischen Verbindung mit dem Leitermaterial teilweise oder vollständig befüllt wird, wobei es sich bei dem Leitermaterial um ein Metall oder ein Halbleitermaterial, bevorzugt Monosilizium oder Polysilizium, handelt.

Durch die Befüllung der Anschlussöffnung mit einem leitfähigen Material kann die elektrische Verbindung zwischen der Anschlussöffnung und dem Durchkontaktierungsbereich hergestellt werden. Dabei sind Metalle und/oder Halbleitermaterialien geeignet, um eine elektrische Verbindung darzustellen. Sie sind in ihrer Herstellung kosten- und aufwandsgünstig und weisen einen hohen Wirkungsgrad auf.

Durch die Anschlussöffnung wird eine vorzugsweise interne elektrische Verbindung an den Durchkontaktierungsbereich bereitgestellt, welche eine Kontaktierung des MEMS-Bauteils mit dem Durchkontaktierungsbereich erlaubt. Die Anschlussöffnung kann dabei in einem Wafer und/oder einem Waferstack gebildet werden. Bevorzugt sind hierfür die obig genannten Ätzverfahren. Durch die Ätzverfahren wird eine Kavität gebildet, die vorzugsweise bis zum Durchkontaktierungsbereich reicht. Weiterhin kann es bevorzugt sein, dass die Anschlussöffnung in den Durchkontaktierungsbereich hinein reicht.

In einem weiteren Aspekt betrifft die Erfindung ein Halbleiterbauteil hergestellt gemäß dem erfindungsgemäßen Verfahren.

Der durchschnittliche Fachmann erkennt, dass technische Merkmale, Definitionen, Vorteile und bevorzugte Ausführungsformen, welche für das erfindungsgemäßen Verfahren zur Herstellung eines Halbleiterbauteils gleichermaßen für das erfindungsgemäß herstellbare Halbleiterbauteil gelten, und umgekehrt.

Das Halbleiterbauteil zeichnet sich durch eine besonders geringe Fehleranfälligkeit und effiziente Bauweise auf. Innerhalb der Device-Schicht des Active-Wafers erfolgt eine interne elektrische Kontaktierung mit dem Durchkontaktierungsbereich. Zudem weisen die MEMS-Strukturen des MEMS-Bauteils eine besonders hohe Sensitivität auf. Das MEMS-Bauteil ist durch einen hermetischen Verschluss besonders gut vor externen Einflüssen geschützt. Dadurch weist das erfindungsgemäße Halbleiterbauteil eine sehr hohe Lebensdauer auf.

Insbesondere weist das Halbleiterbauteil einen Durchkontaktierungsbereich auf, welcher Strom zwischen verschiedenen Leiterbahnebenen transportiert. Vertikale Gräben umschließen den Durchkontaktierungsbereich, die für eine Isolierung des Durchkontaktierungsbereiches sorgen und einen leitfähigen Bereich umschließen.

Zum internen elektrischen Anschluss mit dem Durchkontaktierungsbereich kann eine Anschlussöffnung oder ein Anschlusskontaktbereich mit dem Durchkontaktierungsbereich kontaktiert werden. Bevorzugt wird der Anschlusskontaktbereich durch die Bildung von Trenngräben bereitgestellt. Ebenfalls kann es bevorzugt sein, dass die Trenngräben mit einem zweiten Füllmaterial umfassend ein Dielektrikum befüllt werden. Die Befüllung der Trenngräben kann vollständig oder partiell erfüllen. Auch kann es bevorzugt sein, dass die Trenngräben ungefüllt bleiben. Für den internen Anschluss kann auch eine Anschlussöffnung gebildet werden, die mit einem elektrisch leitfähigen Material befüllt wird.

Für einen externen Anschluss des Durchkontaktierungsbereich weist das Halbleiterbauteil bevorzugt ein Anschlusspad auf dem Durchkontaktierungsbereich auf. Für einen dauerhaften und funktionsgemäßen Betrieb des MEMS-Bauteils, benötigt es einen den elektrischen Anschluss an beiden Anschlussbereichen des Durchkontaktierungsbereiches, nämlich dem internen und dem externen Bereich.

Das erfindungsgemäße Verfahren soll im Folgenden anhand von Beispielen näher erläutert werden, ohne auf diese Beispiele beschränkt zu sein.

### FIGUREN

### Kurzbeschreibung der Figuren

- **Fig. 1 A** - **P**: Darstellung von bevorzugten Verfahrensschritten gemäß einer ersten Ausführungsform der Erfindung
- **Fig. 2 A** - **R**: Darstellung von bevorzugten Verfahrensschritten gemäß einer zweiten Ausführungsform der Erfindung

### Detaillierte Beschreibung der Figuren

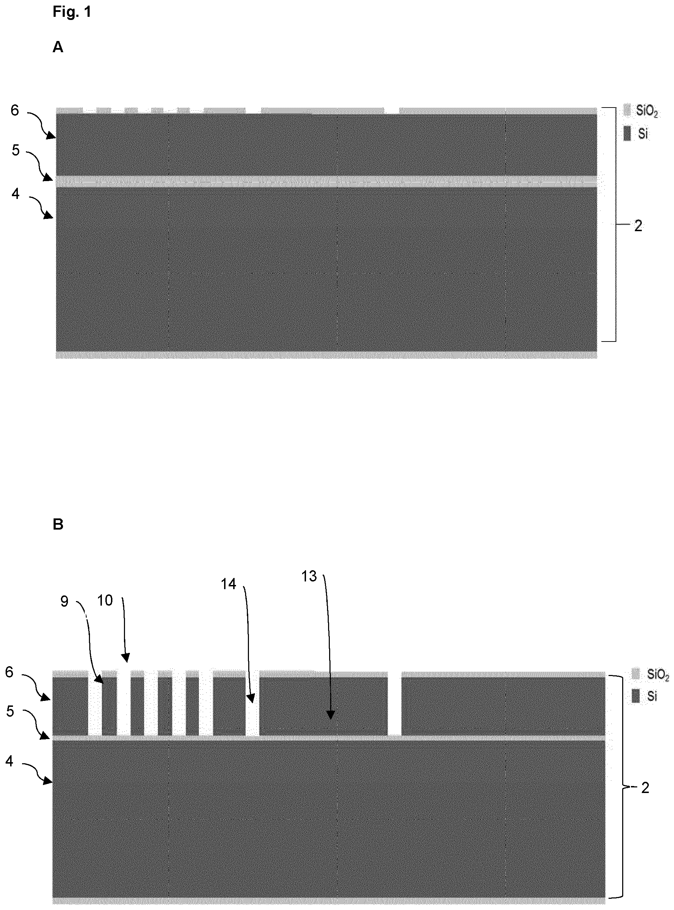

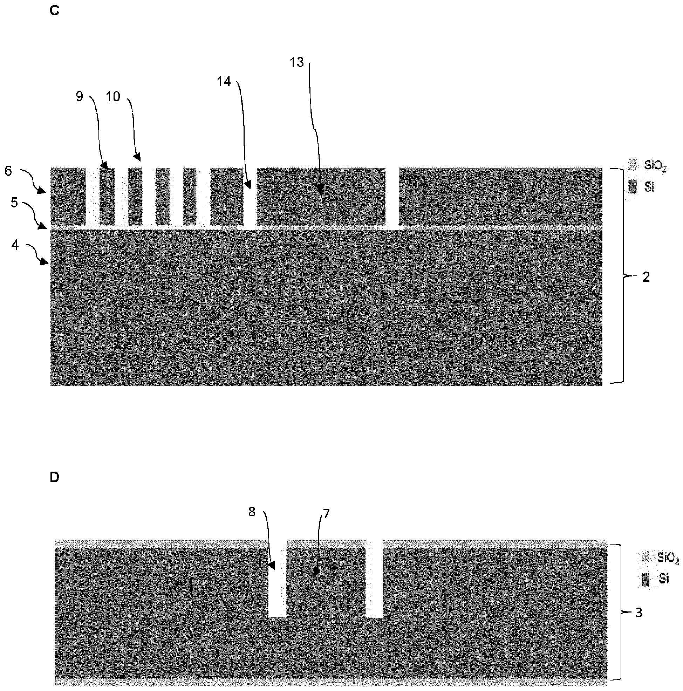

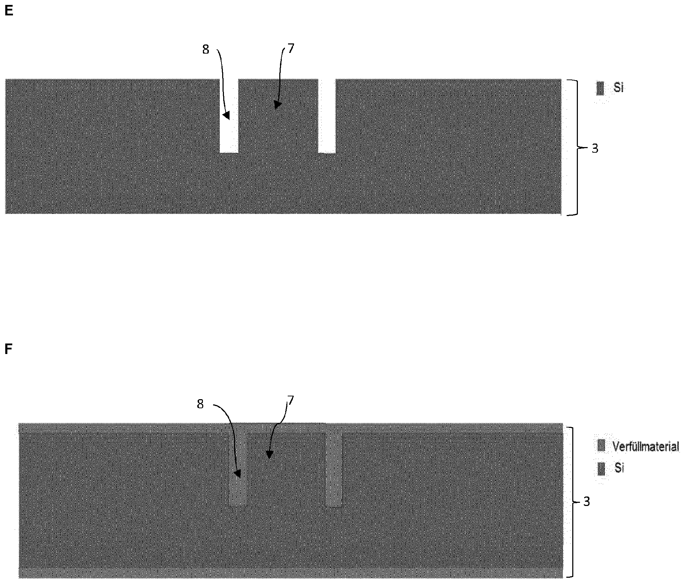

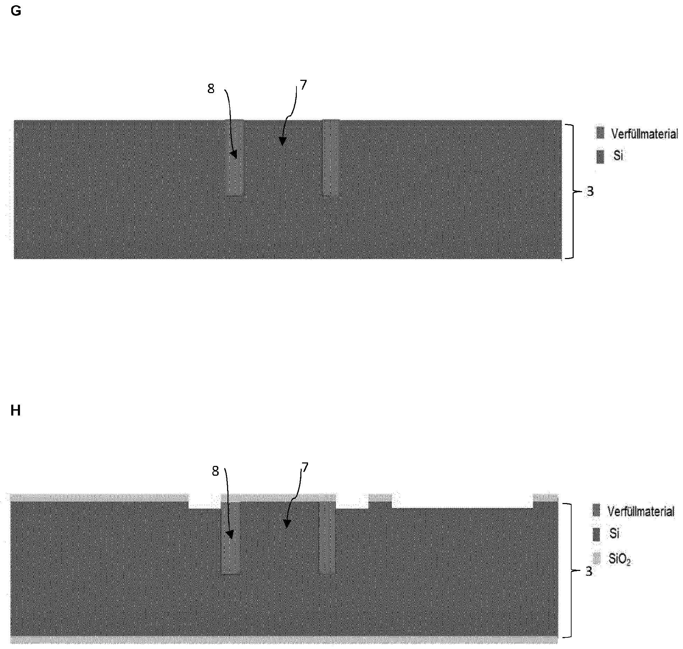

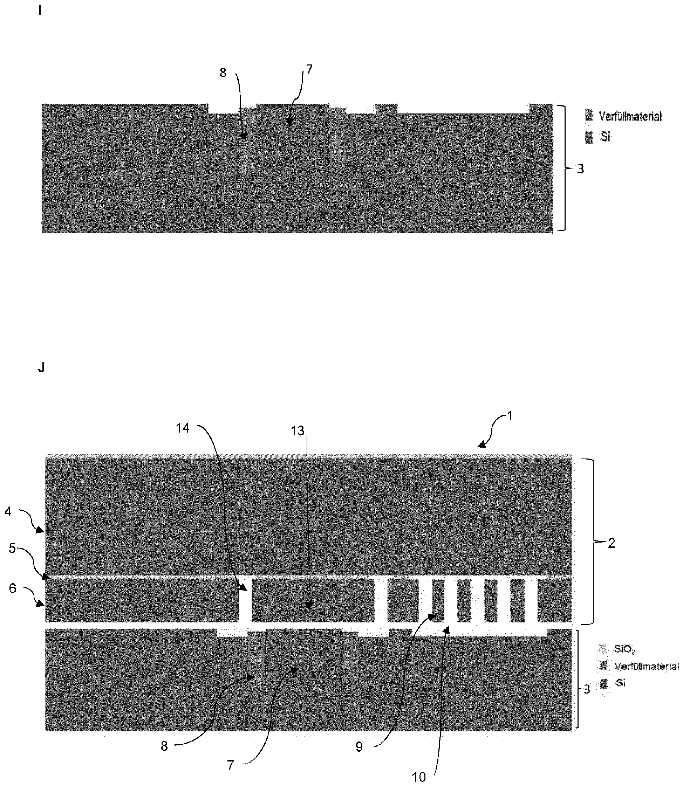

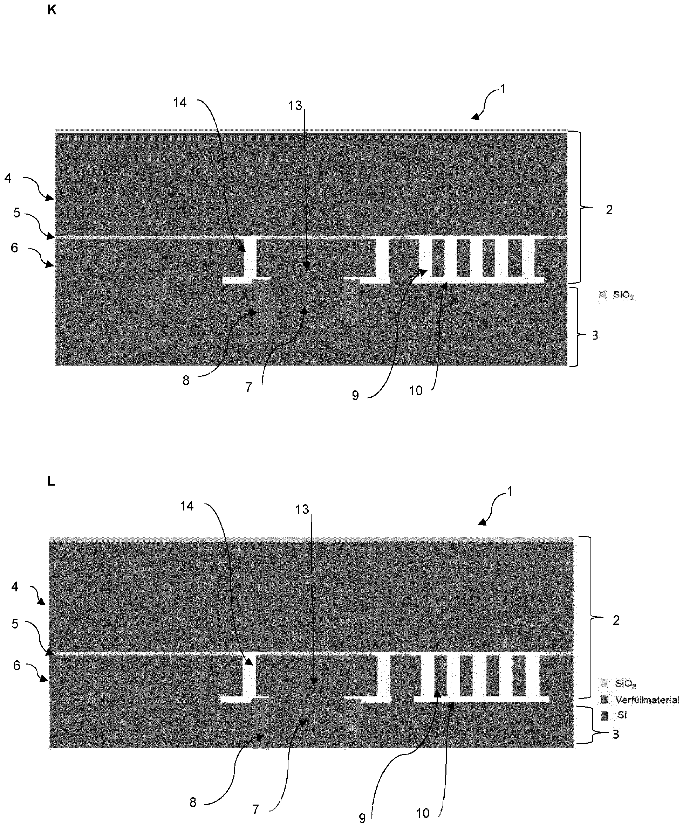

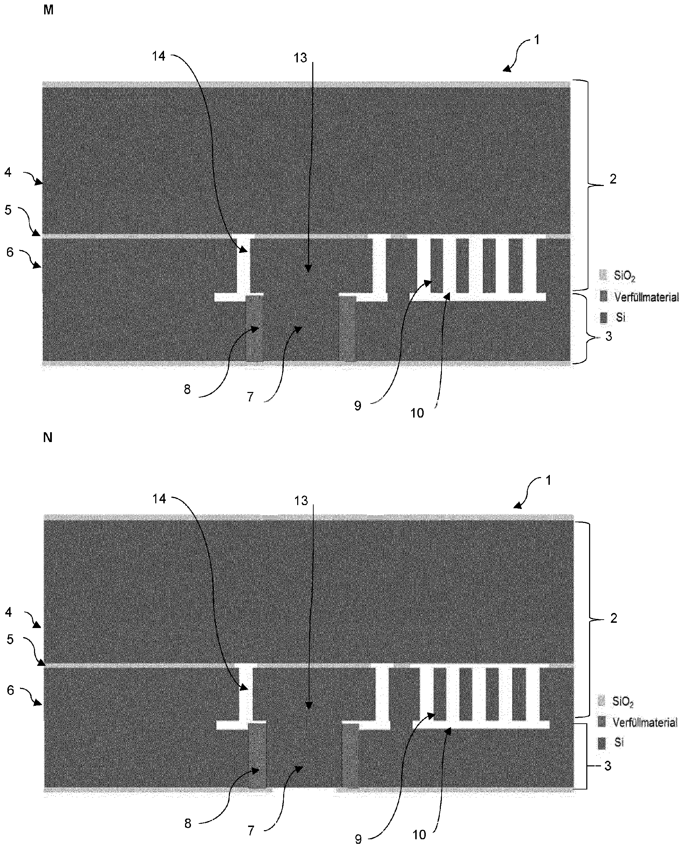

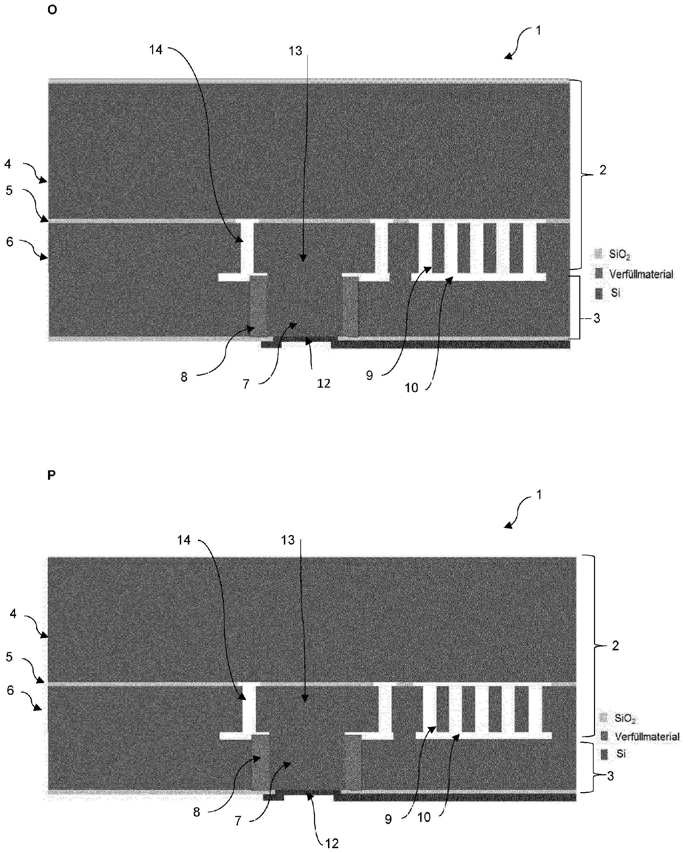

**Fig. 1** zeigt eine Darstellung von bevorzugten Verfahrensschritten **A** - **Q** einer ersten Ausführungsform des erfindungsgemäßen Verfahrens.

Wie obig erläutert, wird ein Halbleiterbauteil **1** hergestellt mit einem Durchkontaktierungsbereich **7** für den Betrieb eines MEMS-Bauteils **10,** wobei sich das MEMS-Bauteil innerhalb einer Kavität eines Waferstacks befindet.

Zur Herstellung des Halbleiterbauteils **1** wird in Verfahrensschritt **A** zunächst ein Active-Wafer **2** als SOI-Wafer bereitgestellt. Der SOI-Wafer umfasst eine Trägerschicht **4,** eine Isolationsschicht **5** und eine Device-Schicht **6.** Die Trägerschicht **4** dient zur Stütze des SOI-Wafers **2,** die Isolationsschicht **5** dient zur Trennung zwischen Trägerschicht **4** und Device-Schicht **6** und stellt insbesondere einen Stoppbereich dar, um den Active-Wafer **2** für weitere Verfahrensschritte, wie beispielsweise durch Ätzverfahren, nicht zu beschädigen. Auf einer Vorderseite bzw. der Device-Schicht des Active-Wafers **2** befindet sich weitere Schicht umfassend Siliziumdioxid SiO₂, wobei diese Schicht strukturiert ist und als Maskierung für das Ätzen dient. Daher kann hierfür auch der Begriff Maskierungsschicht, Isolationsschicht oder Isolierschicht synonym verwendet werden. Der Active-Wafer **2** hat eine ungefähre Dicke von ca. 150 mm, wobei die Device-Schicht **6** ca. 50 µm bzw. 100 µm Device, die Isolationsschicht ca. 2 µm und die Trägerschicht ca. 400 µm dick ist.

Das Anbringen der Maskierungsschicht kann über thermische Oxidation erfolgen und ca. 100 nm dick sein. Die Strukturierung der Maskierungsschicht kann weiterhin über photolothographische Prozesse erfolgen.

Rechts von den Figuren befindet sich eine Legende, die die Materialien der Schichten oder Bereiche des Halbleiterbauteils **1** kennzeichnet.

In Verfahrensschritt **B** wird der Active-Wafer **2** ausgehend von der Device-Schicht **6** in den freigelassenen Bereichen der Maskierung geätzt. Zur Strukturierung der Maskierungsschicht können als Ätzverfahren beispielsweise das RIE (engl. reactive ion etching) eingesetzt werden. Hierzu werden Gräben in den Active-Wafer **2** gebildet. Insbesondere werden hierdurch MEMS-Strukturen **9** für das MEMS-Bauteil **10** und Trenngräben **14** zur Bildung und Isolierung eines Anschlusskontaktbereiches **13** gebildet werden. All diese Gräben reichen in etwa bis zur Isolationsschicht **5,** um die die darunter liegende Trägerschicht **6** nicht zu beschädigen. Vorliegend sind die MEMS-Strukturen **9** als Lamellen dargestellt, wobei entsprechend eine MEMS-Struktur **9** eine Lamelle darstellt. In diesem Verfahrensschritt kann bei der Bildung der Gräben beispielsweise das DRIE (engl. deep reactive ion etching) eingesetzt werden.

In Verfahrensschritt **C** wird durch ein Unterdampfätzen die Isolationsschicht **5** im Bereich der MEMS-Strukturen **9** und der Trenngräben **14** geätzt. Hierbei wird die Isolationsschicht **5** mit einer gasförmigen Säure wie beispielsweise Fluorwasserstoff isotrop geätzt, um insbesondere die MEMS-Strukturen **9** des MEMS-Bauteils **10** freizulegen. Durch ein Freilegen der MEMS-Strukturen **9** können sich diese besonders gut bewegen oder schwingen. Das Unterdampfätzen ist gegenüber Nassätzverfahren hierfür besser geeignet, da beim Unterdampfätzen ein Anhaften der MEMS-Strukturen **9** am Wafer durch Oberflächeneffekte weitestgehend vermieden werden kann. Insbesondere wird bei diesem Verfahrensschritt ein Unterdampfätzen eingesetzt, welches in Zhang et al. (2014) beschrieben wird. Weiterhin wird auch die Maskierungsschicht auf der Vorderseite des Active-Wafers **2** entfernt, um nachher einen geeigneten Bereich für das Bonden bereitzustellen.

In Verfahrensschritt **D** wird ein Cover-Wafer **3** bereitgestellt, welcher ein gewöhnlicher Wafer umfassend Silizium Si ist und an seiner Oberfläche mit SiO₂ als Maskierungsschicht aufgetragen wird. Der Cover-Wafer **3** kann beispielsweise eine Dicke von ca. 150 mm haben. Die Maskierungsschicht wird ebenfalls durch eine thermische Oxidation angebracht und weist eine Schichtdicke von ca. 100 nm auf. Die Maskierungsschicht kann über Photolithographie strukturiert werden. Zur Strukturierung der Maskierungsschicht kann RIE eingesetzt werden. Insbesondere werden in diesem Verfahrensschritt vertikale Gräben **8** gebildet, wodurch der Durchkontaktierungsbereich **7** gebildet wird und die vertikalen Gräben **8** einen leitfähigen Bereich umschließen. Die vertikalen Gräben können beispielsweise eine Tiefe von ca. 50 µm bis ca. 100 µm haben und durch DRIE gebildet werden.

In Verfahrensschritt **E** wird die Maskierungsschicht entfernt, beispielsweise durch nasschemische Ätzverfahren.

In Verfahrensschritt **F** werden die vertikalen Gräben **8** mit einem Verfüllmaterial ausgefüllt. Das Verfüllmaterial (als rot gekennzeichnet) umfasst ein Dielektrikum und dient insbesondere zur Isolierung des Durchkontaktierungsbereiches **7.**

In Verfahrensschritt **G** wird das Verfüllmaterial von der Oberfläche entfernt, beispielsweise durch Polierverfahren. Insbesondere wird das Verfüllmaterial derart entfernt, um eine besonders ebene und planare Oberfläche bereitzustellen, da durch das Entfernen des Verfüllmaterials insbesondere eine geeignete Fläche für das Bonden bereitgestellt werden soll.

In Verfahrensschritt **H** wird SiO₂ durch beispielsweise thermische Oxidation auf der Oberfläche des Cover-Wafers **3** angebracht. Wie auch in den vorherigen Verfahrensschritten kann die Dicke ca. 100 nm betragen. Das SiO₂ wird durch Photolithographie strukturiert und durch RIE geätzt. Weiterhin werden die durch Photolithographie freigestellten Bereiche des Cover-Wafers **3** durch DRIE geätzt, beispielsweise mit einer Tiefe von ca. 2,5 - 5 µm.

In Verfahrensschritt **I** wird das SiO₂ durch Ätzerverfahren von der Oberfläche des Cover-Wafers **3** entfernt, um ebenfalls einen geeigneten Bereich für das Bonden bereitzustellen.

In Verfahrensschritt **J** werden der Active-Wafer **2** und der Cover-Wafer **3** derart aneinander justiert, um im darauffolgenden Schritt das Bonden zu ermöglichen. Bei der Justage befindet sich der Anschlusskontaktbereich **13** des Active-Wafers über dem Durchkontaktierungsbereich **7** des Cover-Wafers **3.** Der Durchkontaktierungsbereich **7** weist zwei Anschlussbereiche auf, die elektrisch kontaktiert werden müssen, um einen Stromkreis für den Betrieb des MEMS-Bauteils **10** zu schließen. Die beiden Anschlussbereiche des Durchkontaktierungsbereiches **7** betreffen insbesondere einen internen und einen externen Anschlussbereich. Der Anschlusskontaktbereich **7** des SOI-Wafers **2** kontaktiert den internen Anschlussbereich des Durchkontaktierungsbereiches **7.**

In Verfahrensschritt **K** werden der Active-Wafer **2** und der Cover Wafer **3** miteinander gebondet. Vor allem werden die beiden Wafer hermetisch miteinander gebondet und das MEMS-Bauteil **10** hierdurch besonders gut geschützt. Durch das Bonden ergibt sich ein robustes, festes und stabiles Halbleiterbauteil **1.** Beim Bonden wird auch der interne Anschlussbereich des Durchkontaktierungsbereiches 7 mit dem Anschlusskontaktbereich **13** kontaktiert, was vorteilhafterweise sehr prozesseffizient ist.

In Verfahrensschritt **L** wird eine Rückseite des Cover-Wafers **3** beispielsweise durch chemisch-mechanisches Polieren abgedünnt. Insbesondere ergibt sich durch das chemisch-mechanische Polieren eine sehr ebene und glatte Waferfläche. Dies verhindert vorteilhafterweise ein Abreißen einer höher gelegenen Schicht, sodass Waferstacks besonders robust und zuverlässig errichtet werden können.

In Verfahrensschritt **M** wird durch thermische Oxidation Siliziumoxid SiO₂ auf die im Verfahrensschritt **L** bearbeitete Oberfläche aufgebracht. Hierbei wird die Schicht für eine Isolierung der Oberfläche angebracht, wenn eine Leiterbahn mit dem externen Anschlussbereich des Durchkontaktierungsbereiches **7** kontaktiert wird.

In Verfahrensschritt **N** wird ein lateraler Bereich des Durchkontaktierungsbereiches **7,** der den externen Anschlussbereich des Durchkontaktierungsbereiches **7** bildet, durch RIE geätzt. Zur Isolierung sind weitere Bereiche vom SiO₂ nicht betroffen.

In Verfahrensschritt **O** wird ein Anschlusspad **12** zur Kontaktierung des externen Anschlussbereiches des Durchkontaktierungsbereiches **7** angebracht, um den Stromkreis für den Betrieb des MEMS-Bauteilts **10** zu schließen. Das Anschlusspad **12** befindet sich in Kontakt mit einer Leiterbahn, beispielsweise ein Metall (durch die dunkelblaue Farbe gekennzeichnet), um den Strom zu leiten.

In einem letzten Verfahrensschritt **P** wird SiO₂, welches sich auf einer Vorderseite bzw. auf der Trägerschicht **4** des SOI-Wafers **2** befindet, durch Ätzverfahren entfernt.

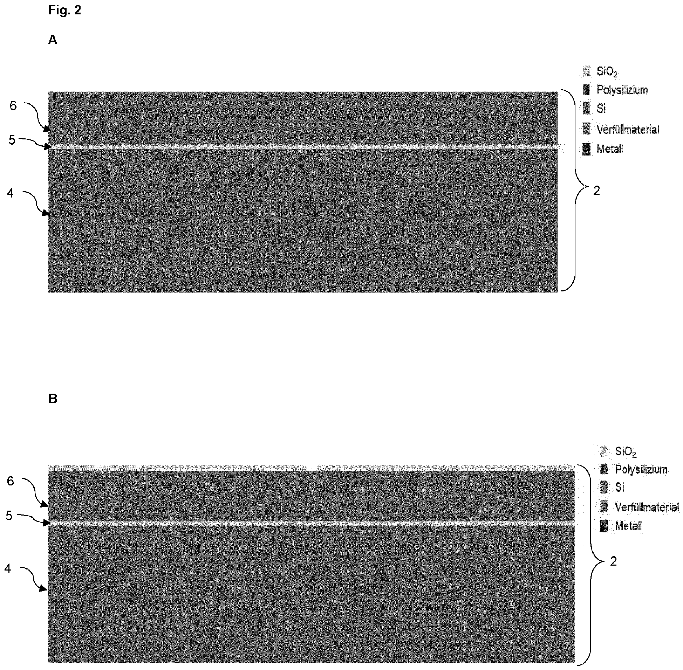

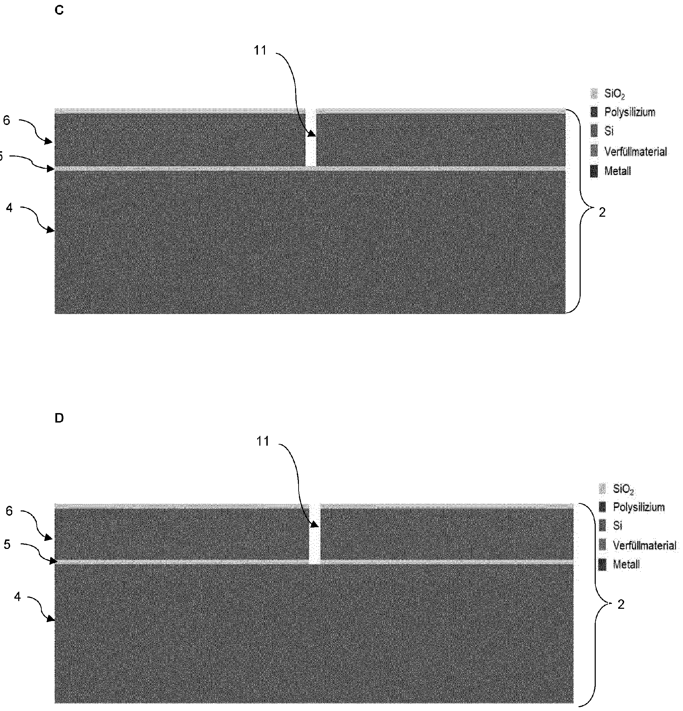

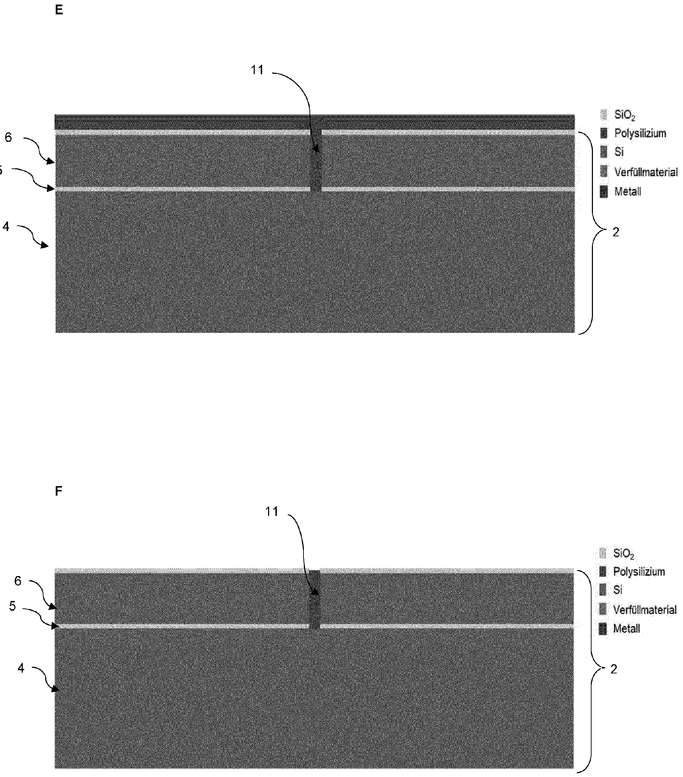

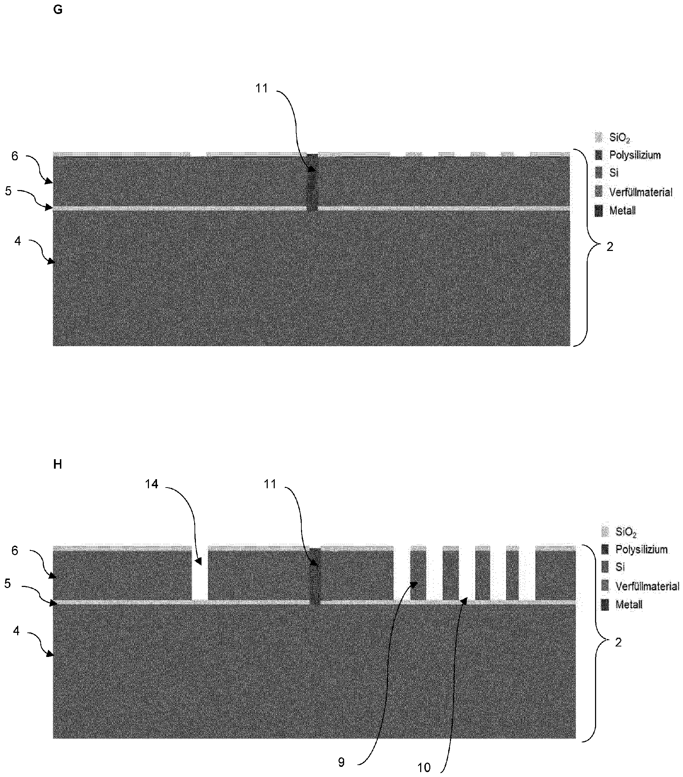

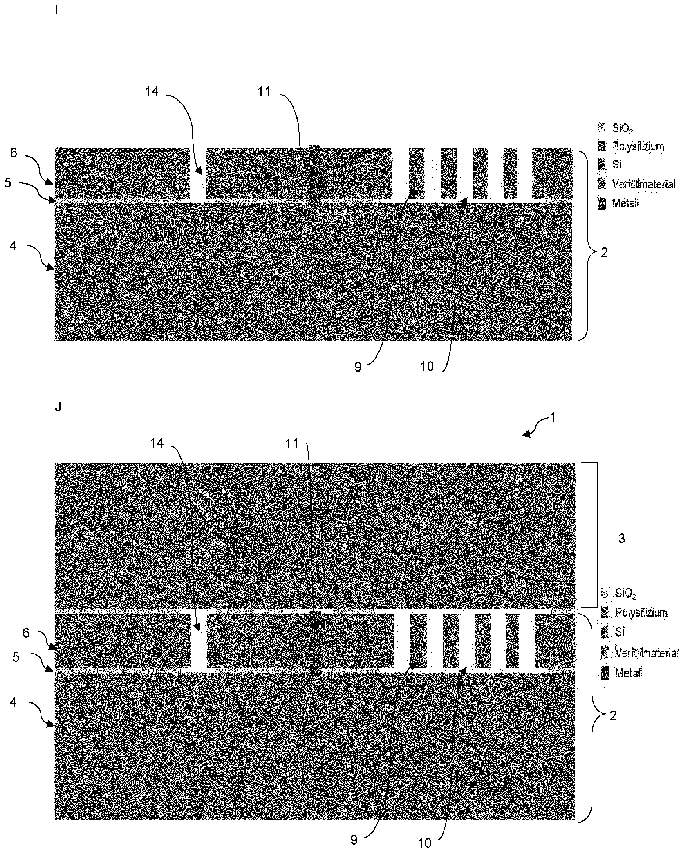

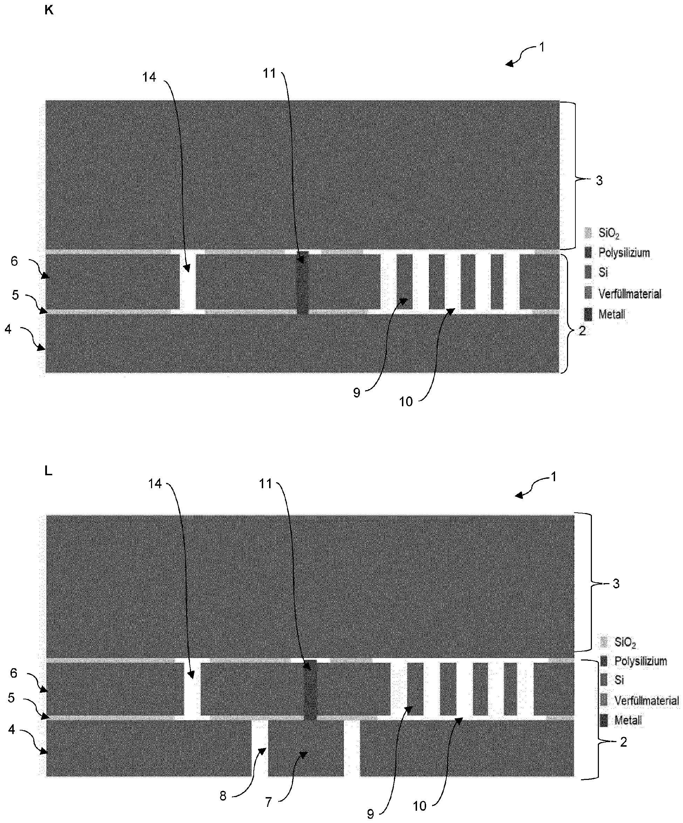

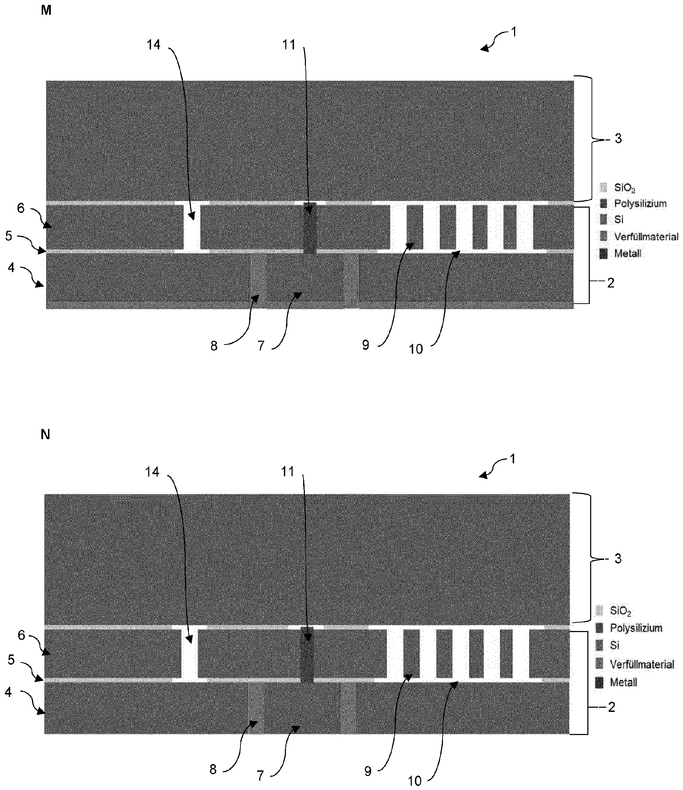

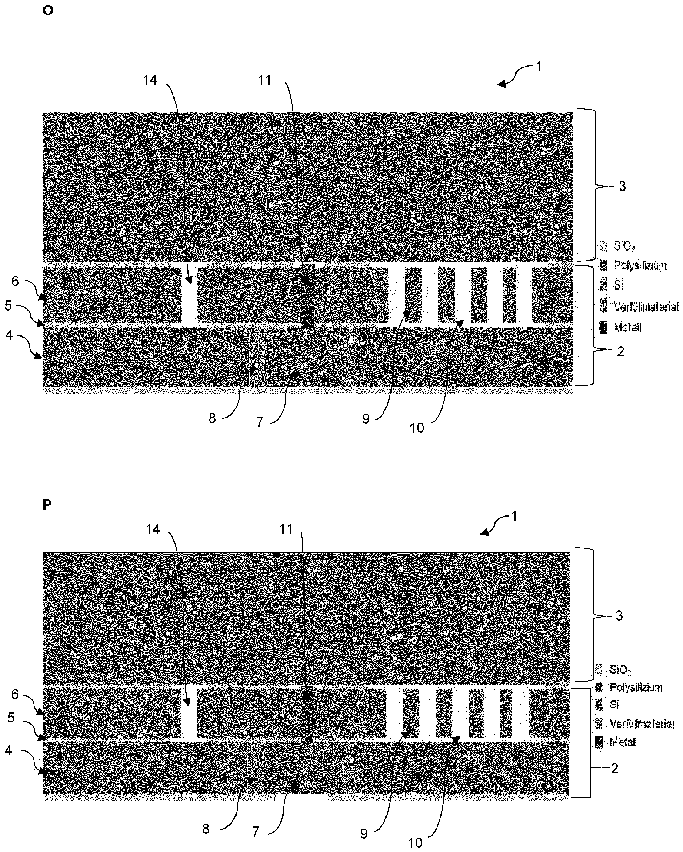

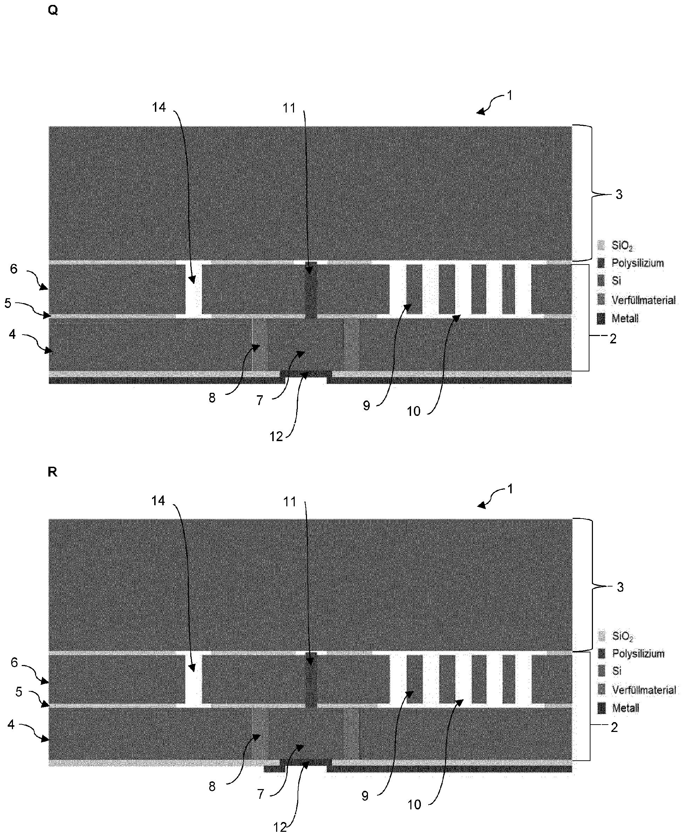

**Fig. 2** zeigt eine Darstellung von bevorzugten Verfahrensschritten **A** - **R** einer weiteren Ausführungsform des erfindungsgemäßen Verfahrens

Hierzu wird in Verfahrensschritt **A** ein Active-Wafer **2** bereitgestellt, der wie im vorherigen Verfahren auch ein SOI-Wafer ist und eine Trägerschicht **4,** eine Isolationsschicht **5** umfassend SiO₂ und eine Device-Schicht **6** umfasst.

In Verfahrensschritt **B** wird über thermische Oxidation SiO₂ auf eine Vorderseite bzw. auf die Device-Schicht **6** des Active-Wafers **2** aufgetragen. Hierbei ist SiO₂, als Maskierungsschicht, strukturiert, um einen Ätzbereich vorgeben zu können.

In Verfahrensschritt **C** wird über DRIE eine Anschlussöffnung **11** gebildet, wobei die Anschlussöffnung **11** bis zur mittleren Isolationsschicht **5** reicht.

In Verfahrensschritt **D** wird über RIE die mittlere Isolationsschicht **5** geätzt.

In Verfahrensschritt **E** wird durch ein Beschichtungsverfahren Polysilizium (lila gekennzeichnet) derart beschichtet, dass dieses die Anschlussöffnung **11** füllt.

Da auch die Vorderseite bzw. die Oberfläche der Device-Schicht **6** durch die Beschichtung mit dem Polysilizium aufgetragen wird, wird in Verfahrensschritt **F** durch RIE das Polysilizium auf der Oberfläche entfernt, um eine glatte Oberfläche zu erhalten.

In Verfahrensschritt **G** wird ebenfalls über RIE die Maskierung bereichsweise entfernt, um Ätzbereiche für die Trenngräben **14** und die MEMS-Strukturen **9** für das MEMS-Bauteil **10** bereitzustellen.

In Verfahrensschritt **H** werden die in Verfahrensschritt G erstellten Bereiche durch DRIE geätzt, um tatsächlich die die Trenngräben **14** und die MEMS-Strukturen **9** für das MEMS-Bauteil **10** zu bilden. Die Gräben reichen hierbei bis zu Isolationsschicht **5** des Active-Wafers **2.**

In Verfahrensschritt **I** wird ein Unterdampfätzen eingesetzt, insbesondere ein Unterdampfätzen, wie es in Zhang et al. (2014) beschrieben wird. Hierbei wird ein Bereich der Isolationsschicht der Trenngräben **14** entfernt und weiterhin die MEMS-Strukturen **9** für das MEMS-Bauteil **10** freigestellt. Hierdurch werden die MEMS-Strukturen **9** translatierbar, rotierbar und/oder schwingfähig.

In Verfahrensschritt **J** wird der Cover-Wafer **4** auf den Active-Wafer **2** durch Bonden angebracht, sodass ein hermetischer Verschluss für das MEMS-Bauteil **10** innerhalb einer Kavität gebildet wird.

In Verfahrensschritt **K** wird die Rückseite des Halbleiterbauteils **1,** vorliegend die Oberfläche der Trägerschicht **4** des Active-Wafers **2** durch Grinding geschliffen und geglättet.

In Verfahrensschritt **L** wird der Durchkontaktierungsbereich **7** an der Trägerschicht **4** des Active-Wafers **2** durch das Erstellen von vertikalen Gräben **8.**

Die vertikalen Gräben **8** werden in Verfahrensschritt **M** mit einem Verfüllmaterial gefüllt, welches insbesondere zur Isolierung des Durchkontaktierungsbereiches **8** fungiert.

In Verfahrensschritt **N** wird das Verfüllmaterial von der Trägerschicht **4** des Active-Wafers **2** geschliffen, um eine glatte und ebene Fläche bereitzustellen, insbesondere für das Anbringen weiterer Isolationsschichten und Leiterbahnen.

In Verfahrensschritt **O** wird SiO₂ auf die Trägerschicht **4** des Active-Wafers **2** angebracht, um für eine Isolierung weiterer Bereiche des Halbleiterbauteils **1** und insbesondere eine gezielte Kontaktierung mit dem Durchkontaktierungsbereich **7** zu ermöglichen.

Für eine gezielte Kontaktierung wird in Verfahrensschritt **P** die Isolierschicht durch RIE am Durchkontaktierungsbereich **7** geätzt.

Durch Füllen dieses ausgelassenen Bereiches mit einem elektrisch leitfähigen Material wird in Verfahrensschritt **Q** der externe Anschluss des Durchkontaktierungsbereiches elektrisch kontaktiert, in dem der Anschlusspad **12** gebildet wird. Dies ist für den Betrieb des MEMS-Bauteils **10** notwendig. Insbesondere befindet sich der Anschlusspad **12** in Kontakt mit einer Leiterbahn, beispielsweise in Form eines Metalls (dunkelblau gekennzeichnet).

In Verfahrensschritt **R** wird die Leiterbahn strukturiert.

### LITERATURVERZEICHNIS

Zhang, Lan, et al. "Amorphous fluoropolymer protective coatings for front-side MEMS releasing by hydrofluoric acid vapor etching." Microelectronic engineering 117 (2014) 18-25.

### Bezugszeichenliste

- 1: Halbleiter-Bauteil
- 2: Active-Wafer
- 3: Cover-Wafer
- 4: Trägerschicht
- 5: Isolationsschicht
- 6: Device-Schicht
- 7: Durchkontaktierungsbereich
- 8: vertikalen Gräben
- 9: MEMS-Strukturen
- 10: MEMS-Bauteil
- 11: Anschlussöffnung
- 12: Anschlusspad
- 13: Anschlusskontaktbereich
- 14: Trenngräben

## Patentansprüche

1. Verfahren zur Herstellung eines Halbleiterbauteils (1) umfassend ein MEMS-Bauteil (10) in einer hermetischen Kavität innerhalb eines von mindestens zwei Wafern gebildeten Waferstacks, umfassend die Schritte:
a) Bereitstellen eines Active-Wafers (2) und eines Cover-Wafers (3), wobei der Active-Wafer (2) eine Trägerschicht (4), eine mittlere Isolationsschicht (5) und eine Device-Schicht (6) aufweist,
b) Bilden von MEMS-Strukturen (9) für das MEMS-Bauteil (10) in der Device-Schicht (6) des Active-Wafers (2) und ein Freistellen der MEMS-Strukturen (9) mithilfe eines Unterätzens,
c) Bilden eines Anschlusskontaktbereiches (13) in der Device-Schicht (6) des Active-Wafers (2) durch Bilden von Trenngräben (14), welche einen leitfähigen Bereich umschließen, oder durch Bilden einer Anschlussöffnung (11), welche mit einem Leitermaterial vollständig oder teilweise befüllt wird,
d) Bilden eines Durchkontaktierungsbereiches (7) durch Bilden von vertikalen Gräben (8) in der Trägerschicht (4) des Active-Wafers (2) oder in dem Cover-Wafer (3), welche den Durchkontaktierungsbereich (7) umschließen,
e) Bonden des Active-Wafers (2) mit dem Cover-Wafer (3) zum hermetischen Einschluss des MEMS-Bauteils (10) in einer Kavität des gebildeten Waferstacks und Anschluss des Durchkontaktierungsbereiches (7) mit einer elektrischen Verbindung zum Betrieb des MEMS-Bauteils (10).

2. Verfahren nach dem vorherigen Anspruch
**dadurch gekennzeichnet, dass**
der Anschlusskontaktbereich (13) in der Device-Schicht (6) des Active-Wafers (2) und der Durchkontaktierungsbereich (7) in dem Cover-Wafer (3) gebildet wird, wobei das Bonden des Active-Wafers (2) mit dem Cover-Wafer (3) derart erfolgt, dass der Durchkontaktierungsbereich (7) zum Anschlusskontaktbereich (13) ausgerichtet vorliegt.

3. Verfahren nach einem oder mehreren der vorherigen Ansprüche
**dadurch gekennzeichnet, dass**
der Anschlusskontaktbereich (13) in der Device-Schicht (6) des Active-Wafers (2) und der Durchkontaktierungsbereich (7) in der Trägerschicht (4) des Active-Wafers (2) gebildet wird, wobei der Durchkontaktierungsbereich (7) zum Anschlusskontaktbereich (13) ausgerichtet vorliegt.

4. Verfahren nach einem oder mehreren der vorherigen Ansprüche
**dadurch gekennzeichnet, dass**
der Active-Wafer (2) ein SOI-Wafer und das Unterätzen zur Freistellen der MEMS-Strukturen (9) mittels eines dampfförmigen Reaktanten erfolgt.

5. Verfahren nach einem oder mehreren der vorherigen Ansprüche
**dadurch gekennzeichnet, dass**
das Freistellen der MEMS-Strukturen (9) durch ein bereichsweises Ätzen der Isolationsschicht (5) des Active-Wafers (2) durch ein Unterätzen erfolgt, wodurch die MEMS-Strukturen (9) bevorzugt translatierbar, rotierbar und/oder schwingfähig werden. und/oder
die MEMS-Strukturen (9) ausgewählt sind aus einer Gruppe umfassend vertikale oder horizontale Lamellen und/oder Mäanderstrukturen umfassend vertikale und horizontale Abschnitte, wobei bevorzugt die Lamellen oder die vertikalen Abschnitte der Mäanderstruktur einen Abstand zueinander bis zu 50 µm, bevorzugt bis zu 10 µm, ganz besonders bevorzugt bis zu 2 µm aufweisen.

6. Verfahren nach einem oder mehreren der vorherigen Ansprüche
**dadurch gekennzeichnet, dass**
die MEMS-Strukturen (9) in der Device-Schicht (6) des Active-Wafers (2) mit einer Strukturierung oder einem Ätzverfahren bevorzugt einem nasschemischen Ätzverfahren und/oder Trockenätzverfahren, bevorzugt physikalische und/oder chemische Trockenätzverfahren, besonders bevorzugt durch reaktives lonenätzen und/oder reaktives lonentiefätzen (Bosch-Prozess) oder Kombinationen der vorgenannten Ätzverfahren gebildet werden.

7. Verfahren nach einem oder mehreren der vorherigen Ansprüche
**dadurch gekennzeichnet, dass**
das MEMS-Bauteil (10) ein Aktuator und/oder ein Sensor ist, bevorzugt ausgewählt aus einer Gruppe umfassend Beschleunigungssensor, Gyroskop, Drucksensor und/oder Strömungssensor.

8. Verfahren nach einem oder mehreren der vorherigen Ansprüche
**dadurch gekennzeichnet, dass**
die vertikalen Gräben (8), die den Durchkontaktierungsbereich (7) für eine Isolierung umschließen, durch nasschemischen Ätzverfahren und/oder Trockenätzverfahren, bevorzugt durch physikalische und/oder chemische Trockenätzverfahren, besonders bevorzugt durch reaktives lonenätzen und/oder reaktives lonentiefätzen (Bosch-Prozess) gebildet werden, wobei bevorzugt die vertikalen Gräben (8) eine Tiefe von im Wesentlichen 100 µm, bevorzugt im Wesentlichen 50 µm, und eine Breite von im Wesentlichen 5 µm, bevorzugt im Wesentlichen 2 µm, aufweisen.

9. Verfahren nach einem oder mehreren der vorherigen Ansprüche
**dadurch gekennzeichnet, dass**
die vertikalen Gräben (8) zur Isolierung des Durchkontaktierungsbereiches (7) mit einem ersten Verfüllmaterial partiell oder vollständig befüllt und verschlossen werden, wobei das erste Verfüllmaterial ein Dielektrikum oder ein elektrisch leitfähiges Material ist, wobei bei der Befüllung mit dem elektrisch leitfähigen Material eine Auskleidung der vertikalen Gräben (8) mit einem Dielektrikum erfolgt.

10. Verfahren nach einem oder mehreren der vorherigen Ansprüche
**dadurch gekennzeichnet, dass**
die vertikalen Gräben (8) mit einem Dielektrikum planar verschlossen werden und/oder die vertikalen Gräben durch eine Auskleidung mit dem Dielektrikum hermetisch verschlossen werden und/oder zum hermetischen Verschließen zusätzlich eine Siegelschicht aufgebracht wird.

11. Verfahren nach einem oder mehreren der vorherigen Ansprüche
**dadurch gekennzeichnet, dass**
auf dem Durchkontaktierungsbereich (7) ein Anschlusspad (12) angebracht wird, wobei zu diesem Zweck bevorzugt zunächst eine Isolierschicht unter zumindest teilweisem Auslassen des Durchkontaktierungsbereiches (7) auf den Cover-Wafer (3) oder den Active-Wafer (2) aufgebracht wird und durch Füllen des ausgelassenen Bereiches mit einem leitfähigen Material das Anschlusspad (12) gebildet wird.

12. Verfahren nach einem oder mehreren der vorherigen Ansprüche
**dadurch gekennzeichnet, dass**
der Anschlusskontaktbereich (13) in der Device-Schicht (6) des Active-Wafers (2) durch die Bildung von Trenngräben (14) gebildet wird, wobei innerhalb der Trenngräben (14) ein Vakuum vorliegt oder die Trenngräben (14) mit einem zweiten Verfüllmaterial befüllt werden.

13. Verfahren nach einem oder mehreren der vorherigen Ansprüche
**dadurch gekennzeichnet, dass**
die Anschlussöffnung (11) ausgehend von der Device-Schicht (6) eines Active-Wafers gebildet wird, wobei zur Bildung der Anschlussöffnung (11) nasschemische Ätzverfahren und/oder Trockenätzverfahren, bevorzugt physikalische und/oder chemische Trockenätzverfahren, besonders bevorzugt durch reaktives lonenätzen und/oder reaktives lonentiefätzen (Bosch-Prozess) oder Kombinationen der vorgenannten Ätzverfahren eingesetzt werden.

14. Verfahren nach einem oder mehreren der vorherigen Ansprüche
**dadurch gekennzeichnet, dass**
die Anschlussöffnung (11) zur Bereitstellung der elektrischen Verbindung mit dem Leitermaterial teilweise oder vollständig befüllt wird, wobei es sich bei dem Leitermaterial um ein Metall oder ein Halbleitermaterial, bevorzugt Monosilizium oder Polysilizium, handelt.

15. Halbleiterbauteil (1) hergestellt gemäß einem Verfahren nach einem oder mehreren der vorherigen Ansprüche.
